**Europäisches Patentamt**

**European Patent Office**

**Office européen des brevets**

(19)

(11) **EP 1 583 246 A1**

(12) **EUROPEAN PATENT APPLICATION**

(43) Date of publication:
**05.10.2005 Bulletin 2005/40**

(51) Int Cl.$^7$: **H03M 13/23**

(21) Application number: **04105655.7**

(22) Date of filing: **10.11.2004**

| | |
|---|---|
| (84) Designated Contracting States:<br>**AT BE BG CH CY CZ DE DK EE ES FI FR GB GR HU IE IS IT LI LU MC NL PL PT RO SE SI SK TR**<br>Designated Extension States:<br>**AL HR LT LV MK YU** | (71) Applicant: **SIEMENS AKTIENGESELLSCHAFT**<br>**80333 München (DE)** |
| (30) Priority: **29.03.2004 EP 04007569** | (72) Inventor: **Bolinth, Edgar**<br>**41189 Mönchengladbach (DE)** |

(54) **Method for terminating a linear convolutional encoder**

(57)     In order to drive an arbitrary linear convolutional encoder from an initial state vector into any desired termination state vector, whereby a code rate of the encoder is defined by R=k/n with k≤n whereby k,n are positive integer numbers, an initial state vector $\mathbf{x}_{(t=p)}$ of the encoder is given and the encoder is mathematically determined by a state input matrix **B**, a state propagation matrix **A**, an encoder output matrix **D** and a state output matrix **C**, it is proposed to calculate a generalised right-hand side pseudo inverse $\mathbf{Q}^{(-1)}_{termination}$ from a termination matrix $\mathbf{Q}_{termination} = [\mathbf{A}^{(\theta-1)}\mathbf{B}, ..., \mathbf{AB}, \mathbf{B}]$, which is a sub matrix of a controllability matrix $\mathbf{Q}_{controllability} =$ $[\mathbf{A}^{(\mu-1)}\mathbf{B}, ..., \mathbf{AB}, \mathbf{B}]$ of the encoder with $\theta<=\mu$, wherein the termination matrix and the controllability matrix have a full row rank $\mu$ and are exponential series of the state propagation matrix **A** multiplied with the state input matrix **B**, and wherein said generalised right-hand side pseudo inverse is multiplied with a sum of a desired termination state vector $\mathbf{x}_{(t=p+\theta)}$ and the propagated initial state vector $\mathbf{A}^\theta\mathbf{x}_{(t=p)}$, such that the product determines a termination sequence $[u_{(t=p)}^T, ..., u_{(t=p+\theta-2)}^T, u_{(t=p+\theta-1)}^T]^T = Q^{(-1)}_{termination}*[X_{(t=p+\theta)} - \mathbf{A}^\theta\mathbf{x}_{(t=p)}]$, which terminates the encoder in $\theta$ steps, wherein $\mu$ is the number of memory elements of the encoder.

FIG 6

EP 1 583 246 A1

**Description**

The invention relates to a method for terminating a linear convolutional encoder.

The invention is based on the object of specifying a method for terminating any arbitrary linear convolutional encoder in which the encoder is driven from an initial state vector into any desired termination state vector.

According to the invention, this object is achieved with the features of claim 1

**Channel coding**

The most famous error correcting codes of practical interest are feed-forward, non-stematic convolutional codes (CC) and recursive systematic convolutional codes (RSC). Recently, also serial and parallel concatenation of convolutional codes have come up, offering superior perfomance compared to simple convolutional codes. The scope of the following sections is to evaluate and compare parallel and serial concatenated convolutional coding schemes.

Before doing this investigation, there is a clear demand to introduce an unambiguous notation for convolutional codes and a scheme to compute the distance spectra of convolutional codes as a major quality criterion. Special attention shall be directed to the applicability of coding techniques, including decoding complexity, trellis termination targeting on codes in observer canonical form and suitable bit-metrics for decoding codes of rate $R = k/n$ with $k > 1$, where $k$ and $n$ denote the number of input and output bits respectively per encoding step.

It will become clear in the following sections, that RSC codes with optimum distance spectra are obtained by algebraic conversion of a feed-forward convolutional code into a recursive systematic structure, while maintaining the original general distance spectra. Unfortunately, equivalence in terms of the distance spectra between feed-forward convolutional codes and recusrsive systematic codes typically implies, that the RSC's are obtained in observer canonical form, which generally require a more sophisticated trellis termination scheme than conventional convolutional codes.

Codes of high code rate are interesting components for code concatenation schemes. As such, for codes of rate $R = k/n$ with more than one information bit per symbol i.e. with $k > 1$, a suitable bit-metric is of essential importance for iterative decoding. Keeping in mind that the code structure offers only a natural symbol-metric, a suitable bit-metric will be derived.

Finally, for some concatenated coding schemes, the effective minimum free distance of the overall code will be computed. It will be shown in one of the following sections, that convolutional codes with optimum distance spectra offer superior performance. Moreover, while comparing parallel and serial concatenated codes, the huge potential of serial code concatenation schemes will be demonstrated.

**Convolutional codes**

The traditional notation for convolutional codes of code rate $R = k/n$ is a polynomial generator matrix $\mathbf{G}_{(z)}$ of size $[k \times n]$ and $k \leq n$, which maps a k-ary, polynomial input vector $\mathbf{U}_{(z)}$ onto a n-ary, polynomial output vector $\mathbf{Y}_{(z)}$, such that the following equation holds:

$$Y_{(z)}^{T} = U_{(z)}^{T}G_{(z)}. \tag{1}$$

The polynomial vectors $\mathbf{U}_{(z)}^{T}$ and $\mathbf{Y}_{(z)}^{T}$ are linked to the binary input and output sequences $u_{(t)}^{T}$ and $y_{(t)}^{T}$ via the following Laplace transforms:

$$U_{(z)}^{T} \bullet\!\!-\!\!\circ u_{(t)}^{T} = (u_{1(t)}, u_{1(t)}, ..., u_{k(t)})^{T} \tag{2}$$

$$Y_{(z)}^{T} \bullet\!\!-\!\!\circ y_{(t)}^{T} = (y_{1(t)}, y_{2(t)}, ..., y_{k(t)})^{T}. \tag{3}$$

In this context the Laplace transform is defined over a polynomial ring of binary elements $F_2(z)$, whereas the superscript $T$ denotes the vector transpose.

A different definition of convolutional codes comes from linear control and sytem theroy. Here the convolutional code is defined by a state-space equation 4 and an encoder equation 5, using a set of constant, binary matrices [**ABCD**]:

$$x_{(t+1)} = Bu_{(t)} + Ax_{(t)} \tag{4}$$

$$y_{(t)} = Du_{(t)} + Cx_{(t)} \tag{5}$$

The value adding property of the equations 4, 5 compared to the generator matrix notation $G_{(z)}$ is the state-vector $x^T_{(t)} = (x_{1(t)}, x_{2(t)}, ..., x_{\mu(t)})^T$, which offers an unambiguous description of the state transitions from state $\mathbf{x}_{(t)}$ at time instant $t$ to the successor state $x_{(t+1)}$ at instant $(t + 1)$, where $\mu$ denotes the number of memory elements. The successor state $x_{(t+1)}$ is clearly defined by the superposition of two components: first, the state-propagation matrix $\mathbf{A}$ of size $[\mu \times \mu]$, which describes the influence of the predecessor state $x_{(t)}$ and second, the state-input matrix $\mathbf{B}$ of size $[\mu \times k]$. It can also be said, that the encoder input $u_{(t)}$ drives the follow-up state $x_{(t+1)}$ via the state-input matrix $\mathbf{B}$. The state-output matrix $\mathbf{C}$ of size $[n \times \mu]$ reads out the predecessor state $x_{(t)}$, which is added to the encoder output. Finally, the matrix $\mathbf{D}$ is of size $[n \times \mu]$ can be described as the delay-free component of the encoder input, which directly influences the encoder output. Based on the state-space description of the encoder 4, 5 the generator matrix $G_{(z)}$ can be recovered by the following steps. First the encoder equation 5 and the state-space representation 4 are transformed via the Laplace transform over $F_2(z)$:

$$Y_{(z)} = DU_{(z)} + CX_{(z)} \tag{6}$$

$$z^{(-1)}X_{(z)} = BU_{(z)} + AX_{(z)}. \tag{7}$$

Second, by adding $\mathbf{AX}_{(z)}$ on both sides of equation 7 and by using modulo 2 addition rules over $F_2(z)$ the polynomial state-vector can be written as follows:

$$X_{(z)} = (z^{(-1)}I + A)^{(-1)}BU_{(z)}. \tag{8}$$

The transpose of the generator matrix $G(z)$ can be computed by using equation 6 and 8.

$$G^T_{(z)} = \frac{Y_{(z)}}{U_{(z)}} = D + C(z^{(-1)}I + A)^{(-1)}B. \tag{9}$$

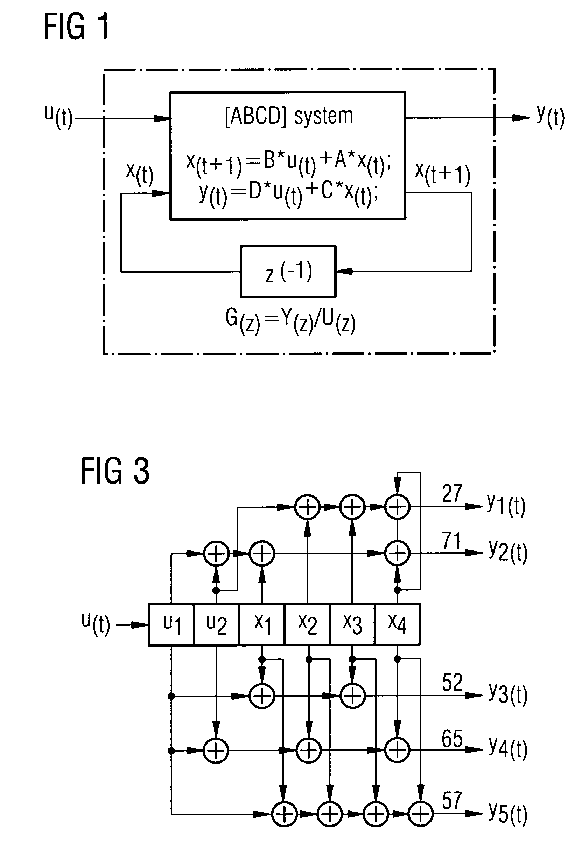

It can be seen from equation 9, that the main qualitative difference between the Laplace domain representation of the generator matrix $G_{(z)}$ and time domain representation [$\mathbf{ABCD}$] is given by the fact, that the [$\mathbf{ABCD}$]-system representation offers a clear and unambiguous description of the state-space. This relation is highlighted in figure 1.
From linear system theory it is known, that there are many equivalent systems, having the same generator matrix $G_{(z)}$. Any minimal [$\mathbf{ABCD}$]-system can be converted into an equivalent [$\tilde{A}\tilde{B}\tilde{C}\tilde{D}$]-system with identical mapping of input to output bits. The state-space is converted via $\tilde{x}_{(t)} = \mathbf{Q}x_{(t)}$, where $\mathbf{Q}$ is an invertible matrix of size $[\mu \times \mu]$.

$$\tilde{x}_{(t+1)} = \mathbf{Q}x_{(t+1)} = \mathbf{Q}Bu_{(t)} + \mathbf{Q}A\mathbf{Q}^{(-1)}\mathbf{Q}x_{(t)} = \tilde{B}u_{(t)} + \tilde{A}\tilde{x}_{(t)} \tag{10}$$

$$y_{(t)} = Du_{(t)} + C\mathbf{Q}^{(-1)}\mathbf{Q}x_{(t)} = \tilde{D}u_{(t)} + \tilde{C}\tilde{x}_{(t)} \tag{11}$$

Consequently the generating matrix $\tilde{G}^T_{(z)}$ equals $G^T_{(z)}$, as shown subsequently:

$$
\begin{aligned}
\tilde{\mathbf{G}}_{(z)}^T &= \tilde{\mathbf{D}} + \tilde{\mathbf{C}}(z^{(-1)}\mathbf{I} + \tilde{\mathbf{A}})^{(-1)}\tilde{\mathbf{B}} \\
&= \mathbf{D} + \mathbf{C}\mathbf{Q}^{(-1)}(z^{(-1)}\mathbf{Q}\mathbf{Q}^{(-1)} + \mathbf{Q}\mathbf{A}\mathbf{Q}^{(-1)})^{(-1)}\mathbf{Q}\mathbf{B} \\
&= \mathbf{D} + \mathbf{C}(z^{(-1)}\mathbf{I} + \mathbf{A})^{(-1)}\mathbf{B} = \mathbf{G}_{(z)}^T.
\end{aligned}
\tag{12}
$$

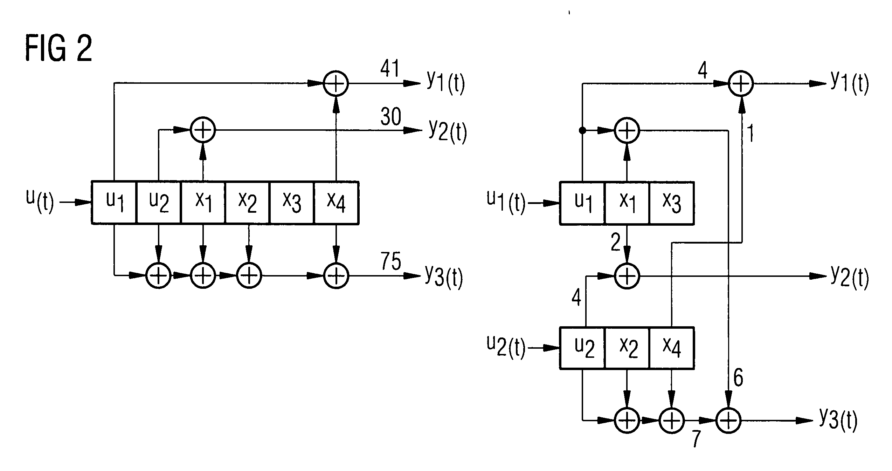

In figure 2 an example of a serial and a parallel shift register implementation of the same generator matrix is presented. It is easily verified, that the parallel implementation is achieved by re-arranging the register elements of the serial implementation. Implementations, where to each input bit *k* a separate input queue is assigned, are called encoders in controller canonical form (cef).

Both notations are of common practice. Extensive tables of non-systematic convolutional codes in parallel representations can be found in [1] and [2], whereas the serial representation is widely used in [3,4] and [5].

$$
\mathbf{G}\frac{serial\ ccf}{oct} = [41,\ 30,\ 75];\ R = 2/3;\ \mu = 3;
\tag{13}
$$

$$
\mathbf{G}_{oct}^{parallel\ ccf} = \begin{pmatrix} 4 & 2 & 6 \\ 1 & 4 & 7 \end{pmatrix};\ R = 2/3;\ \mu = 3;
\tag{14}
$$

Moreover, both implementations produce the same sequence mapping of input bits to output bits, independent of the number of used memory elements. The corresponding generator matrix reads as follows:

$$
\mathbf{G}_{(z)} = \begin{bmatrix} 1 & z & z+1 \\ z^2 & 1 & z^2+z+1 \end{bmatrix};\ R = 2/3;\ \mu = 3;
\tag{15}
$$

Obviously, the number of memory elements $\mu$ determines not only the decoding complexity, but also the state-space of the code. Moreover, as a consequence of that, it also determines the distance spectra of the code. In the following, the utilization of the [**ABCD**]-system notation, will clearly distinguish between a $\mu = 4$ implementation of the code and a minimal implementation with $\mu = 3$. Interestingly, both system implementations lead to the same generator matrix, as given in equation 15. In [**ABCD**] representation with $\mu = 4$ the encoder depicted in figure 2 can be written as follows:

$$
\mathbf{y}_{(t)} = [\mathbf{D}|\mathbf{C}] \begin{bmatrix} \mathbf{u}_{(t)} \\ \mathbf{x}_{(t)} \end{bmatrix} = \begin{bmatrix} y_{1(t)} \\ y_{2(t)} \\ y_{3(t)} \end{bmatrix} = \underbrace{\begin{bmatrix} 1 & 0 & 0 & 0 & 0 & 1 \\ 0 & 1 & 1 & 0 & 0 & 0 \\ 1 & 1 & 1 & 1 & 0 & 1 \end{bmatrix}}_{=\begin{bmatrix} 41 \\ 30 \\ 75 \end{bmatrix}} \begin{bmatrix} u_{1(t)} \\ u_{2(t)} \\ x_{1(t)} \\ x_{2(t)} \\ x_{3(t)} \\ x_{4(t)} \end{bmatrix}
\tag{16}
$$

$$\mathbf{x}_{(t+1)} = [\mathbf{B}|\mathbf{A}] \begin{bmatrix} \mathbf{u}_{(t)} \\ \mathbf{x}_{(t)} \end{bmatrix} = \begin{bmatrix} x_{1(t+1)} \\ x_{2(t+1)} \\ x_{3(t+1)} \\ x_{4(t+1)} \end{bmatrix} = \begin{bmatrix} 1 & 0 & 0 & 0 & 0 & 0 \\ 0 & 1 & 0 & 0 & 0 & 0 \\ 0 & 0 & 1 & 0 & 0 & 0 \\ 0 & 0 & 0 & 1 & 0 & 0 \end{bmatrix} \begin{bmatrix} u_{1(t)} \\ u_{2(t)} \\ x_{1(t)} \\ x_{2(t)} \\ x_{3(t)} \\ x_{4(t)} \end{bmatrix} \tag{17}$$

From figure 2 it can also be seen, that the memory element $x_{3(t)}$ does not influence neither the encoder output $y_{(t)}$ or any other memory element $x_{(t+1)}$, as the k-ary input symbols $u_{(t)}$ are fed in at once. Hence the memory element labelled $x_{3(t)}$ can be removed from the state-space and the encoder equation. After deleting the third row from the matrices **B** and **A**, followed by deleting the third column from the modified matrix **A** and from matrix **C**, the new [A†B†C†D†]-system representation with μ = 3 is as follows:

$$\mathbf{y}_{(t)} = [\mathbf{D}^\dagger|\mathbf{C}^\dagger] \begin{bmatrix} \mathbf{u}_{(t)} \\ \mathbf{x}^\dagger_{(t)} \end{bmatrix} = \begin{bmatrix} y_{1(t)} \\ y_{2(t)} \\ y_{3(t)} \end{bmatrix} = \begin{bmatrix} 1 & 0 & 0 & 0 & 1 \\ 0 & 1 & 1 & 0 & 0 \\ 1 & 1 & 1 & 1 & 1 \end{bmatrix} \begin{bmatrix} u_{1(t)} \\ u_{2(t)} \\ x^\dagger_{1(t)} \\ x^\dagger_{2(t)} \\ x^\dagger_{3(t)} \end{bmatrix} \tag{18}$$

$$\mathbf{x}^\dagger_{(t+1)} = [\mathbf{B}^\dagger|\mathbf{A}^\dagger] \begin{bmatrix} \mathbf{u}_{(t)} \\ \mathbf{x}^\dagger_{(t)} \end{bmatrix} = \begin{bmatrix} 1 & 0 & 0 & 0 & 0 \\ 0 & 1 & 0 & 0 & 0 \\ 0 & 0 & 0 & 1 & 0 \end{bmatrix} \begin{bmatrix} u_{1(t)} \\ u_{2(t)} \\ x^\dagger_{1(t)} \\ x^\dagger_{2(t)} \\ x^\dagger_{3(t)} \end{bmatrix} \tag{19}$$

Now, it can easily be verified, that both the [**ABCD**] and [A†B†C†D†] implementations have the same generator matrix:

$$\begin{aligned} \mathbf{G}_{(z)} &= \begin{bmatrix} 1 & z & z+1 \\ z^2 & 1 & z^2+z+1 \end{bmatrix} \\ &= \left[\mathbf{D} + \mathbf{C}(z^{(-1)}\mathbf{I} + \mathbf{A})^{(-1)}\mathbf{B}\right]^T \\ &= \left[\mathbf{D}^\dagger + \mathbf{C}^\dagger(z^{(-1)}\mathbf{I} + \mathbf{A}^\dagger)^{(-1)}\mathbf{B}^\dagger\right]^T . \end{aligned} \tag{20}$$

It should be mentioned, that the [**ABCD**]-implementation according to the equations 17, 16 is not linked to the minimal [**A†B†C†D†**]-implementation according to equations 19, 18 via similarity transform, as defined in the equations 10 and 11. Similarity transforms, by definition preserve memory size μ, as the state-space conversion matrix Q

is square and has full rank.

Another aspect is, that the distance spectra of the code is also determined by the state-space of the code. Commonly, the general distance spectra of a convolutional code is a measure of the amount of code words $(y^T_{(t),}$, $y^T_{(t+1)}$, ..., $y^T_{(t+p)}$ with $p \to \infty$, as a function of its Hamming distance. Expanding the distance spectra $T_{(W)}$ into a Taylor series, the exponent denotes the Hamming distance, whereas the integer coefficients count the corresponding code words. Anticipating the calculation method of distance spectra for convolutional codes presented in one of the enclosed sections, for the [**ABCD**]-implementation given in the equations 16, 17 and the [**A$^\dagger$B$^\dagger$C$^\dagger$D$^\dagger$**]-implementation given in the equations 18 and 19 the distance spectra $T_{(W)}$ and $T^\dagger_{(W)}$ are as follows:

$$T_{(W)}|^{\mu=4} =$$

$$- \frac{W^4(1-W^9+2W^4+29W^5+3W^6-19W^7-3W^8+3W^{11}+5W-2W^2-15W^3)}{2W^{15}+2W^{13}-2W^{12}-12W^{11}-W^{10}+3W^9+3W^8+7W^7+2W^6-W^5-2W^4+2W^2+3W-1}. \tag{21}$$

$$T^\dagger_{(W)}|^{\mu=3} = - \frac{W^4(1+5W-2W^2-15W^3+2W^4+29W^5+3W^6-19W^7-3W^8-W^9+3W^{11})}{2W^{13}-2W^{10}-13W^9+W^8+15W^7+3W^6-3W^5-3W^4+2W^2+3W-1}. \tag{22}$$

From the denominator of equations 21 and 22 it becomes clear, that different sizes in terms of the state-space generally lead to different distance spectra. For the present example, equation 23 quantifies the amount of additional, dominant code words with respect to its Hamming distance, available in the set of code words of the [**ABCD**]-implementation compared to the minimal [**A$^\dagger$B$^\dagger$C$^\dagger$D$^\dagger$**]-implementation.

$$T_{(W)} - T^\dagger_{(W)} = W^8 + 13\,W^9 + 80\,W^{10} + 371\,W^{11} + 1597\,W^{12} +$$

$$6751\,W^{13} + ... \tag{23}$$

It can generally be concluded, that convolutional codes with optimum distance spectra have to be minimal in the sense of linear control and system theory. Naturally this holds only if the encoder implementation does not show a catastrophic behaviour.

**Equivalence between non-systematic, feed-forward and recursive systematic codes**

In the following, the technical terms *code, code implementation, generator matrix* and *equivalent generator matrix* will be defined more clearly.

In standard coding theory [5] the term *code* is commonly defined as the set of code words or the set of code sequences $(\mathbf{y}^T_{(t=0),}, \mathbf{y}^T_{(t=1),}, ..., y^T_{(t=p),})$ where $p$ is sufficiently large. Consequently, the term code, does not include any other information such as the dimension of the state-space or mapping rules from the information sequence to the code sequence.

The term *generator matrix* is a mapping rule, describing how an information input sequence $(u^T_{(t=0)}, u^T_{(t=1)}, ..., u^T_{(t=p)})$ is mapped onto a code sequence $(y^T_{(t=0)}, y^T_{(t=1)}, ..., y^T_{(t=p)})$ where $p$ is an arbitrary integer number. Typically, the *generator matrix* $\mathbf{G}_{(z)}$ is defined as polynomial matrix in the time-discrete Laplace domain over binary elements. An appropriate definition of $\mathbf{G}_{(z)}$ has already been given in equation 9, also demonstrating that the dimension of the state-space is not unique.

The technical term *code implementation* or *encoder* addresses a specific implementation of a digital and linear time-invariant (LTI) system. In general, such a LTI-system can be described via the [**ABCD**]-system representation as defined by the equations 4 and 5. In addition to the sequence mapping rules, a *code implementation* includes specifically a precise definition of the state-space.

Two *generator matrices* $\mathbf{G}'_{(z)}$ and $\mathbf{G}_{(z)}$ are called *equivalent*, if both matrices generate the same *code*, i.e. the same set of code sequences. In mathematical terms *equivalence* is fulfilled, if there exists a polynomial scrambling

matrix $\mathbf{L}_{(z)}$ of size $[k\times k]$ with det $(\mathbf{L}_{(z)}) \neq 0$, such that the following equation holds:

$$G'_{(z)} = L_{(z)}G_{(z)}. \tag{24}$$

The condition det $(\mathbf{L}_{(z)}) \neq 0$ requires $\mathbf{G}'_{(z)}$ to have full row rank, given the case that $\mathbf{G}_{(z)}$ does also have full row rank. In other words, this condition demands the existance of a unique polynomial inverse $L_{(z)}^{(-1)}$ to convert $\mathbf{G}'_{(z)}$ into $\mathbf{G}_{(z)}$ and vice versa. Typically equiv*alent generator matrices* do generate the same *code,* but generally may produce different *specific* Hamming distance spectra i.e. the *input-output mapping* is different.

In contrast to that, two *generator matrices* $\mathbf{G}'_{(z)}$ and $\mathbf{G}_{(z)}$ are called *strictly equivalent,* if they generate the same *general* Hamming distance spectra. In this case the matrices $\mathbf{G}'_{(z)}$ and $\mathbf{G}_{(z)}$ refer to *code implementations* which are memory persistent, i.e. the dimension of the state-space $\mu$ is kept constant. It is known from coding theory [5], that each non-systematic, feed-forward convolutional code of rate $R = k/n$ can be converted into a recursive systematic code via equivalence transform according to equation 24. As an additional condition, it is required that the reverse polynomial transformation matrix $\mathbf{L}_{(z)}^{(-1)}$ is delay free i.e. any input symbol $\mathbf{u}_{(t)}$ has immediate impact on the encoder output $\mathbf{y}_{(t)}$. Mathematically this condition reads as follows:

$$\det\left\{\mathbf{L}_{(z)}^{(-1)}\right\}\Big|_{z=0} = 1. \tag{25}$$

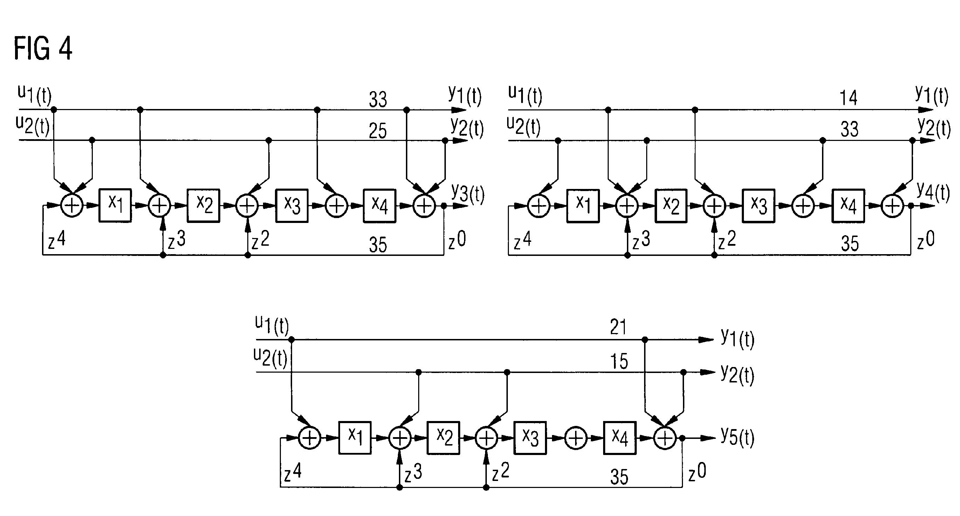

In the following, a general method to convert non-systematic, feed-forward convolutional codes into systematic recursive codes will be presented, while keeping *strict equivalence* between the generator matrices. As the applicability of systematic recursive codes is a matter of special interest, the design goal of the conversion algorithm is to generate a *code implementation* in [**ABCD**]-form, which produces the same distance spectra as the original, non-systematic convolutional code. The proposed conversion method will be explained in the following, using the encoder example depicted in figure 3 with generator matrix $\mathbf{G}_{(z)}^{ccf}$ :

$$\mathbf{G}_{(z)}^{ccf} = \begin{bmatrix} z^2 & z+1 & z^2+z+1 & 1 & z^2+z+1 \\ z^2+z+1 & z^2+1 & 0 & z^2+z+1 & z^2+z \end{bmatrix}. \tag{26}$$

By choosing the first $[k \times k]$ submatrix of $\mathbf{G}_{(z)}^{ccf}$ as the reverse transformation matrix $\mathbf{L}_{(z)}^{(-1)}$, the following equations can be found:

$$\mathbf{L}_{(z)}^{(-1)} \stackrel{def}{=} \begin{bmatrix} z^2 & z+1 \\ z^2+z+1 & z^2+1 \end{bmatrix} ; \quad \det\left(\mathbf{L}_{(z)}^{(-1)}\right) = z^4 + z^3 + z^2 + 1. \tag{27}$$

$$\mathbf{L}_{(z)} = \begin{bmatrix} \frac{z+1}{z^3+z+1} & \frac{1}{z^3+z+1} \\ \frac{z^2+z+1}{z^4+z^3+z^2+1} & \frac{z^2}{z^4+z^3+z^2+1} \end{bmatrix}. \tag{28}$$

Further, by inserting equations 26 and 28 into equation 24 by using $\mathbf{G}'_{(z)} = \mathbf{G}_{(z)}^{ocf}$, the equivalent generator

matrix of the systematic recursive code in observer canonical form (ocf) is computed:

$$\mathbf{G}_{(z)}^{ocf} = \mathbf{L}_{(\mathbf{z})}\mathbf{G}_{(z)}^{ccf}$$

$$= \begin{bmatrix} 1 & 0 & \frac{z^3+1}{z^3+z+1} & \frac{z^2}{z^3+z+1} & \frac{z^3+z^2+z+1}{z^3+z+1} \\ \\ 0 & 1 & \frac{z^4+z^2+1}{z^4+z^3+z^2+1} & \frac{z^3+1}{z^3+z+1} & \frac{z^3+z^2+1}{z^4+z^3+z^2+1} \end{bmatrix}$$

$$= \begin{bmatrix} 1 & 0 & \frac{z^4+z^3+z+1}{z^4+z^3+z^2+1} & \frac{z^3+z^2}{z^4+z^3+z^2+1} & \frac{z^4+1}{z^4+z^3+z^2+1} \\ \\ 0 & 1 & \frac{z^4+z^2+1}{z^4+z^3+z^2+1} & \frac{z^4+z^3+z+1}{z^4+z^3+z^2+1} & \frac{z^3+z^2+1}{z^4+z^3+z^2+1} \end{bmatrix} \tag{29}$$

$$\Rightarrow \begin{bmatrix} 1 & 0 & \frac{33}{35} & \frac{14}{35} & \frac{21}{35} \\ \\ 0 & 1 & \frac{25}{35} & \frac{33}{35} & \frac{15}{35} \end{bmatrix}.$$

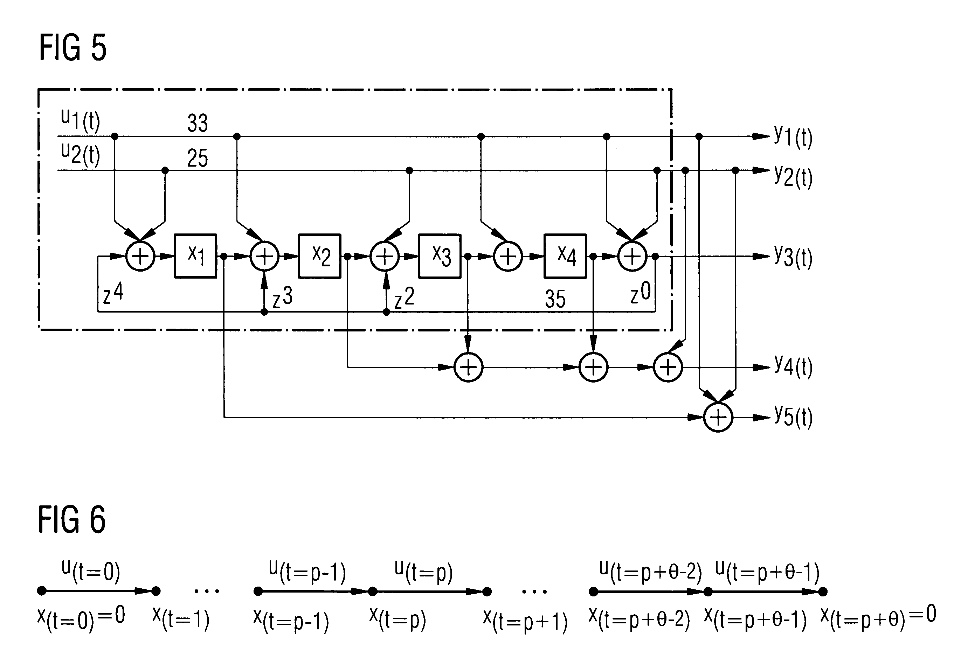

It is easily verified from equation 29, that the resulting generator matrix $\mathbf{G}_{(z)}^{ocf}$ consists of $k$ systematic columns and $(n - k)$ non-systematic columns. In a first step for each of the non-systematic columns, a separate $[\mathbf{A}_m\mathbf{B}_m\mathbf{C}_m\mathbf{D}_m]$ intermediate implementation with $m$ = 1,..., $(n - k)$ in observer canonical form will be given. The second, and last step merges all intermediate implementations into one single implementation $[\mathbf{A}^{ocf}\mathbf{B}^{ocf}\mathbf{C}^{ocf}\mathbf{D}^{ocf}]$, while the total memory size of $\mu$ = 4 is kept at equal size as the original encoder in figure 3. The corresponding intermediate and merged encoder structures are shown in figures 4 and 5. Following and extending the notation used in [6] for multiple non-systematic columns, the octal notation for the generator matrix $\mathbf{G}_{(z)}^{ocf}$ of equation 29 can be rewritten as shown in equation 30.

$$\mathbf{G}_{oct}^{parallel\ ocf} = \begin{bmatrix} 33 & 25 & 35 \\ 14 & 33 & 35 \\ 21 & 15 & 35 \end{bmatrix}. \tag{30}$$

The notation $\mathbf{G}_{oct}^{parallel\ ocf}$ uses $(n - k)$ rows, i.e. one single row for each non-systematic component, and $(k + 1)$ columns. The first $k$ columns represent the input connections for every single input element of the $k$-ary input symbol, whereas the last $(k + 1)$-th column represents the feed-back polynomial for each of the non-systematic code componets. In order to describe each of the non-systematic components in a compact form the following notation will be used:

$$\begin{bmatrix} \mathbf{y}_{(t)} \\ \mathbf{x}_{m(t+1)} \end{bmatrix} = \begin{bmatrix} \mathbf{D}_m & \mathbf{C}_m \\ \mathbf{B}_m & \mathbf{A}_m \end{bmatrix} \begin{bmatrix} \mathbf{u}_{(t)} \\ \mathbf{x}_{m(t)} \end{bmatrix} \tag{31}$$

For the first non-systematic component $\mathbf{G}_{oct(1,1:k+1)}^{parallel\ ocf}$ the intermediate $[\mathbf{A}_m\mathbf{B}_m\mathbf{C}_m\mathbf{D}_m]$ system is computed:

$$
1\text{-st:}\quad
\begin{bmatrix} \mathbf{D}_1 & \mathbf{C}_1 \\ \mathbf{B}_1 & \mathbf{A}_1 \end{bmatrix}
\begin{bmatrix} \mathbf{u}_{(t)} \\ \mathbf{x}_{1(t)} \end{bmatrix}
=
\left[\begin{array}{cc|cccc}
1 & 0 & 0 & 0 & 0 & 0 \\
0 & 1 & 0 & 0 & 0 & 0 \\
1 & 1 & 0 & 0 & 0 & 1 \\ \hline
0 & 0 & 0 & 0 & 0 & 1 \\
0 & 1 & 1 & 0 & 0 & 1 \\
1 & 0 & 0 & 1 & 0 & 1 \\
1 & 0 & 0 & 0 & 1 & 0
\end{array}\right]
\begin{bmatrix} u_{1(t)} \\ u_{2(t)} \\ \hline x_{1(t);m=1} \\ x_{2(t);m=1} \\ x_{3(t);m=1} \\ x_{4(t);m=1} \end{bmatrix}
=
\begin{bmatrix} y_{1(t)} \\ y_{2(t)} \\ y_{3(t)} \\ \hline x_{1(t+1);m=1} \\ x_{2(t+1);m=1} \\ x_{3(t+1);m=1} \\ x_{4(t+1);m=1} \end{bmatrix}
.(32)
$$

Based on figure 4 the matrices $\mathbf{A}_1$, $\mathbf{D}_1$ and $\mathbf{C}_1$ are easily obtained by setting up linear system equations. In general terms the input matrix $\mathbf{B}_1$ is recovered in a similar way. To achieve this, an additive compensation term $[(\mathbf{A}_{1\,(1:\mu,\mu)},0)^T \mathbf{D}_{1\,(k+1,1:k)}]$, must further be added to the transposed input vector $\mathbf{G}^{parallel\ ocf}_{oct\,(1,1:k)}$, as resented below:

$$
\begin{bmatrix} \mathbf{B}_1 \\ \mathbf{D}_{1\,(k+1,1:k)} \end{bmatrix}
=
\underbrace{\begin{bmatrix} 33 \\ 25 \end{bmatrix}^T}_{=\left(\mathbf{G}^{parallel\ ocf}_{oct\,(1,1:k)}\right)^T}
+
\begin{bmatrix} \mathbf{A}_{1\,(1:\mu,\mu)} \\ 0 \end{bmatrix}
\mathbf{D}_{1\,(k+1,1:k)}
$$

$$
=
\left[\begin{array}{cc} 1 & 1 \\ 1 & 0 \\ 0 & 1 \\ 1 & 0 \\ \hline 1 & 1 \end{array}\right]
+
\left[\begin{array}{c} 1 \\ 1 \\ 1 \\ 0 \\ \hline 0 \end{array}\right]
\begin{bmatrix} 1 & 1 \end{bmatrix}
=
\left[\begin{array}{cc} 1 & 1 \\ 1 & 0 \\ 0 & 1 \\ 1 & 0 \\ \hline 1 & 1 \end{array}\right]
+
\left[\begin{array}{cc} 1 & 1 \\ 1 & 1 \\ 1 & 1 \\ 0 & 0 \\ \hline 0 & 0 \end{array}\right]
=
\left[\begin{array}{cc} 0 & 0 \\ 0 & 1 \\ 1 & 0 \\ 1 & 0 \\ \hline 1 & 1 \end{array}\right]
\qquad (33)
$$

Using the same procedure the 2-nd and the 3-rd non-systematic components are given by:

$$2\text{-nd:}\quad \begin{bmatrix} \mathbf{D}_2 & \mathbf{C}_2 \\ \mathbf{B}_2 & \mathbf{A}_2 \end{bmatrix} = \left[\begin{array}{cc|cccc} 1 & 0 & 0 & 0 & 0 & 0 \\ 0 & 1 & 0 & 0 & 0 & 0 \\ 0 & 1 & 0 & 0 & 0 & 1 \\ \hline 0 & 0 & 0 & 0 & 0 & 1 \\ 1 & 0 & 1 & 0 & 0 & 1 \\ 1 & 1 & 0 & 1 & 0 & 1 \\ 0 & 1 & 0 & 0 & 1 & 0 \end{array}\right]$$

$$(34)$$

$$3\text{-rd:}\quad \begin{bmatrix} \mathbf{D}_3 & \mathbf{C}_3 \\ \mathbf{B}_3 & \mathbf{A}_3 \end{bmatrix} = \left[\begin{array}{cc|cccc} 1 & 0 & 0 & 0 & 0 & 0 \\ 0 & 1 & 0 & 0 & 0 & 0 \\ 1 & 1 & 0 & 0 & 0 & 1 \\ \hline 0 & 1 & 0 & 0 & 0 & 1 \\ 1 & 0 & 1 & 0 & 0 & 1 \\ 1 & 0 & 0 & 1 & 0 & 1 \\ 0 & 0 & 0 & 0 & 1 & 0 \end{array}\right]$$

As already discussed, a strict equivalence between the original, non-systematic convolutional code and the recursive systematic code can only be achieved if the total number of memory elements $\mu$ is kept constant. This directly demands a second conversion step, which merges all intermediate $[\mathbf{A}_m\mathbf{B}_m\mathbf{C}_m\mathbf{D}_m]$ non-systematic components into one single representation. One of the non-systematic components can be selected as a mapping reference i.e. as a basis to which all other component encoders are mapped. In the example depicted in figure 4 the first component is selected as basis $[\mathbf{A}_b\mathbf{B}_b\mathbf{C}_b\mathbf{D}_b] = [\mathbf{A}_1\mathbf{B}_1\mathbf{C}_1\mathbf{D}_1]$. Using equation 4 the impact of the information sequence $(u^T_{(t=0)}, u^T_{(t=1)}, ..., u^T_{(t=\mu-1)})$ to the final state $x(t=\mu+1)$ can be described by the following equation:

$$\mathbf{x}_{b(t=\mu)} = \underbrace{\left[ \mathbf{A}_b^{(\mu-1)}\mathbf{B}_b, \quad \mathbf{A}_b^{(\mu-2)}\mathbf{B}_b, \quad \cdots, \quad \mathbf{A}_b\mathbf{B}_b, \quad \mathbf{B}_b \right]}_{\overset{def}{=}\mathbf{Q}_b} \begin{bmatrix} \mathbf{u}_{(t=0)} \\ \mathbf{u}_{(t=1)} \\ \vdots \\ \mathbf{u}_{(t=\mu-2)} \\ \mathbf{u}_{(t=\mu-1)} \end{bmatrix} + \mathbf{A}_b^\mu \mathbf{x}_{b(t=0)} \quad (35)$$

Without loss of generality, the initial state $x_{(t=0)}$, can be set to the all-zero state. The matrix $Q_b$ describes how the input sequence $(u^T_{(t=0)}, u^T_{(t=1)}, ..., u^T_{(t=\mu-1)})$ drives the state sequence $(x^T_{b(t=1)}, x^T_{b(t=1)}, ..., x^T_{b(t=\mu)})$ and as such offers a basis of the state-space if $Q_b$ has full row rank. It can also be said, that the column vectors of $\mathbf{Q}_b$ represent a basis of the state-space $x_b$. Orienting on equation 35 for the 2-nd and 3-rd non-systematic code component a different state-space $x_m$ can be found by $\mathbf{Q}_m$, if $m \neq b$:

$$\mathbf{x}_{m(t=\mu)} = \underbrace{\left[ \ \mathbf{A}_m^{(\mu-1)}\mathbf{B}_m, \ \ \mathbf{A}_m^{(\mu-2)}\mathbf{B}_m, \ \cdots, \ \ \mathbf{A}_m\mathbf{B}_m, \ \ \mathbf{B}_m \ \right]}_{\overset{def}{=}\mathbf{Q}_m} \begin{bmatrix} \mathbf{u}_{(t=0)} \\ \mathbf{u}_{(t=1)} \\ \vdots \\ \mathbf{u}_{(t=\mu-2)} \\ \mathbf{u}_{(t=\mu-1)} \end{bmatrix} + \mathbf{A}_m^{\mu}\mathbf{x}_{m(t=0)} \quad (36)$$

The task of merging non-systematic components corresponds to the task of converting state-spaces. To be precise, for each non-systematic component only one single row vector $C^{ocf}_{(k+m,1:\mu)}$ using the state-space $x_b$, needs to be found as posted by equation 37.

$$C^{ocf}_{(k+m,1:\mu)} = C_{m(k+1,1:\mu)}Q_m Q_b^{(-1)} \ . \tag{37}$$

The remaining code components can just be re-used, according to the equations in 38.

$$\begin{aligned} \mathbf{A}^{ocf} &= \mathbf{A}_b \\ \mathbf{B}^{ocf} &= \mathbf{B}_b \\ \mathbf{D}^{ocf}_{(k+m,1:k)} &= \mathbf{D}_{m(k+1,1:k)} \end{aligned} \tag{38}$$

For the example depicted in figure 4 and the intermediate $[\mathbf{A}_m\mathbf{B}_m\mathbf{C}_m\mathbf{D}_m]$ system implementation according to equations 32 and 34, the final state-output vectors $C^{ocf}_{(k+m,1:\mu)}$ can be computed. With $\mathbf{Q}_b^{(-1)}$, $\mathbf{Q}_2$ and $\mathbf{Q}_3$

$$\mathbf{Q}_b = \mathbf{Q}_1 = \begin{bmatrix} 1 & 1 & 1 & 0 & 1 & 0 & 0 & 0 \\ 0 & 1 & 0 & 0 & 1 & 0 & 0 & 1 \\ 1 & 1 & 0 & 0 & 1 & 1 & 1 & 0 \\ 0 & 0 & 1 & 1 & 1 & 0 & 1 & 0 \end{bmatrix} \tag{39}$$

$$\left(\mathbf{Q}_b^{(-1)}\right)^T = \begin{bmatrix} 0 & 0 & 1 & 1 & 0 & 0 & 0 & 0 \\ 1 & 1 & 0 & 0 & 0 & 0 & 0 & 0 \\ 1 & 0 & 1 & 1 & 0 & 0 & 0 & 0 \\ 0 & 0 & 0 & 1 & 0 & 0 & 0 & 0 \end{bmatrix} \tag{40}$$

$$
\mathbf{Q}_2 = \begin{bmatrix} 1 & 1 & 1 & 1 & 0 & 1 & 0 & 0 \\ 0 & 0 & 1 & 0 & 0 & 1 & 1 & 0 \\ 0 & 1 & 1 & 0 & 1 & 1 & 1 & 1 \\ 1 & 0 & 1 & 1 & 1 & 1 & 0 & 1 \end{bmatrix} \quad \mathbf{Q}_3 = \begin{bmatrix} 1 & 0 & 1 & 0 & 0 & 0 & 0 & 1 \\ 0 & 0 & 1 & 0 & 0 & 1 & 1 & 0 \\ 0 & 0 & 1 & 1 & 1 & 0 & 1 & 0 \\ 1 & 1 & 1 & 0 & 1 & 0 & 0 & 0 \end{bmatrix} \quad (41)
$$

and with $m = 2, 3$ the state-output vectors $\mathbf{C}^{ocf}_{(k+m,1:\mu)}$ according to equation 37 are:

$$
\mathbf{C}^{ocf}_{(k+2,1:\mu)} = \mathbf{C}_{2(k+1,1:\mu)}\mathbf{Q}_2\mathbf{Q}_1^{(-1)} = \begin{bmatrix} 0 & 0 & 0 & 1 \end{bmatrix} \begin{bmatrix} 0 & 0 & 1 & 1 \\ 1 & 0 & 1 & 0 \\ 1 & 1 & 1 & 0 \\ 0 & 1 & 1 & 1 \end{bmatrix} = \begin{bmatrix} 0 & 1 & 1 & 1 \end{bmatrix}.
$$

$$(42)$$

$$
\mathbf{C}^{ocf}_{(k+3,1:\mu)} = \mathbf{C}_{3(k+1,1:\mu)}\mathbf{Q}_3\mathbf{Q}_1^{(-1)} = \begin{bmatrix} 0 & 0 & 0 & 1 \end{bmatrix} \begin{bmatrix} 1 & 1 & 0 & 0 \\ 1 & 0 & 1 & 0 \\ 0 & 0 & 0 & 1 \\ 1 & 0 & 0 & 0 \end{bmatrix} = \begin{bmatrix} 1 & 0 & 0 & 0 \end{bmatrix}.
$$

$$(43)$$

Finally the recursive systematic code implementation in observer canonical from can be put together as described by equation 44. The corresponding shift register implementation is shown in figure 5.

$$
\begin{bmatrix} \mathbf{y}_{(t)} \\ \mathbf{x}_{(t+1)} \end{bmatrix} = \begin{bmatrix} \mathbf{D}^{ocf} & \mathbf{C}^{ocf} \\ \mathbf{B}^{ocf} & \mathbf{A}^{ocf} \end{bmatrix} \begin{bmatrix} \mathbf{u}_{(t)} \\ \mathbf{x}_{(t)} \end{bmatrix} = \begin{bmatrix} \begin{array}{cc|cccc} 1 & 0 & 0 & 0 & 0 & 0 \\ 0 & 1 & 0 & 0 & 0 & 0 \\ 1 & 1 & 0 & 0 & 0 & 1 \\ 0 & 1 & 0 & 1 & 1 & 1 \\ 1 & 1 & 1 & 0 & 0 & 0 \\ \hline 0 & 0 & 0 & 0 & 0 & 1 \\ 0 & 1 & 1 & 0 & 0 & 1 \\ 1 & 0 & 0 & 1 & 0 & 1 \\ 1 & 0 & 0 & 0 & 1 & 0 \end{array} \end{bmatrix} \begin{bmatrix} u_{1(t)} \\ u_{2(t)} \\ \mathbf{x}_{(t)} \end{bmatrix} = \begin{bmatrix} y_{1(t)} \\ y_{2(t)} \\ y_{3(t)} \\ y_{4(t)} \\ y_{5(t)} \\ \mathbf{x}_{(t+1)} \end{bmatrix}
$$

$$(44)$$

For the sake of simplicity an octal notation is introduced. In this notation the elements of $\mathbf{A}^{ocf}_{oct}$ and $\mathbf{B}^{ocf}_{oct}$ corre-

spond to the columns of the binary matrices $\mathbf{A}^{ocf}$ and $\mathbf{B}^{ocf}$, whereas the elements of $\mathbf{D}^{ocf}_{oct}$ and $\mathbf{C}^{ocf}_{oct}$ correspond to the rows of their binary counterparts $\mathbf{D}^{ocf}$ and $\mathbf{B}^{ocf}$. For the example presented in equation 44 the octal notation $[\mathbf{A}^{ocf}_{oct}\mathbf{B}^{ocf}_{oct}\mathbf{C}^{ocf}_{oct}]$ is as follows:

$$
\begin{aligned}
\mathbf{A}^{ocf}_{oct} &= \begin{bmatrix} 4 & 2 & 1 & 16 \end{bmatrix} \\
\mathbf{B}^{ocf}_{oct} &= \begin{bmatrix} 3 & 4 \end{bmatrix} \\
\mathbf{C}^{ocf}_{oct} &= \begin{bmatrix} 0 & 0 & 1 & 7 & 10 \end{bmatrix}^T \\
\mathbf{D}^{ocf}_{oct} &= \begin{bmatrix} 2 & 1 & 3 & 1 & 3 \end{bmatrix}^T .
\end{aligned}
\tag{45}
$$

The presented conversion procedure can, without loss of generality, be applied to any non-catastrophic, non-systematic, feed-forward convolutional code of rate $R = k/n$. The result is a recursive systematic code in observer canonical form in the sense of figure 5. The resulting encoder implementation has the same number of memory elements as the original, non-systematic encoder and as a consequence they generate identical *general* Hamming distance spectra $T_{(W)}$. Of course the *specific* Hamming distance spectra, which also includes the specific mapping of input symbols to output symbols, is different.

In table 1 all non-systematic, feed-forward convolutional codes with $R = k/n$ and $n > k + 1$ from [3] have been converted. For the enlisted codes *strict equivalence* between the original non-systematic code and the recursive systematic code has been verified by computing the generating function $\mathbf{G}_{(z)}$ based on equation 9. Additionally, for all codes with $\mu \leq 4$ a precise computation of the general Hamming distance spectra has been performed, proving that the distance spectra are identical.

A mathematical derivation of the aforementioned *merging procedure* is still missing. No efforts have been spent for investigating a general proof of equation 37. As a matter of fact, for this proof there is only limited theoretical interest and nearly no practical interest. From a practical point of view, the codes enlisted in table 1 are proved in terms of *strict equivalence* and as a consequence offer a sufficient description for implementation.

Rather than a mathematical proof, an intuitive explanation of equation 37 will be given instead. Starting with equations 35 and 36 a state-space conversion matrix $\mathbf{Q}^{(-1)}_{m \to b}$ of size $[\mu \times \mu]$ can be defined as follows:

$$
\mathbf{x}_{m(t=\mu)} = \underbrace{\mathbf{Q}_m \mathbf{Q}^{(-1)}_b}_{\overset{def}{=} \mathbf{Q}^{(-1)}_{m \to b}} \mathbf{x}_{b(t=\mu)}.
\tag{46}
$$

In the case, that $\mathbf{Q}^{(-1)}_{m \to b}$ has full rank, the merging procedure can be understood as similarity transform according to:

$$
\mathbf{x}_{b(t+1)} = \mathbf{Q}_{m \to b}\mathbf{x}_{m(t+1)} = \underbrace{\mathbf{Q}_{m \to b}\mathbf{B}_m}_{= \mathbf{B}_b} \mathbf{u}_{(t)} + \mathbf{Q}_{m \to b}\mathbf{A}_m \mathbf{Q}^{(-1)}_{m \to b} \underbrace{\mathbf{Q}_{m \to b}\mathbf{x}_{m(t)}}_{= \mathbf{x}_{b(t)}}.
\tag{47}
$$

$$
\mathbf{y}_{(t)} = \mathbf{D}_m \mathbf{u}_{(t)} + \underbrace{\mathbf{C}_m \mathbf{Q}^{(-1)}_{m \to b}}_{= \mathbf{C}_{m \to b} \overset{def}{=} \mathbf{C}^{ocf}_m \text{ as defined in equation 37.}} \overbrace{\mathbf{Q}_{m \to b}\mathbf{x}_{m(t)}}^{= \mathbf{x}_{b(t)}}.
\tag{48}
$$

However, the state-space conversion matrix $\mathbf{Q}^{(-1)}_{m \to b}$ does not always have full rank, as for instance $\mathbf{Q}^{(-1)}_{2 \to 1} =$

$\mathbf{Q}_2\mathbf{Q}_1^{(-1)}$ in equation 42. Consequently, the merging procedure cannot be considered as a similarity transform in the strict sence, because a unique inverse $(\mathbf{Q}_{m \to b}^{(-1)})^{(-1)} = \mathbf{Q}_{m \to b}$ does not exist. The conversion matrix $\mathbf{Q}_{m \to b}^{(-1)}$ should rather be interpreted as the projection from state-space $\mathbf{x}_m$ to state-space $\mathbf{x}_b$, which is used to make a transformation of the row vectors of the state-output matrix $\mathbf{C}_m$ to a different state-space basis $\mathbf{x}_b$.

**Termination over the minimal Trellis**

A *minimal* encoder implementation [**ABCD**] generates a different Hamming distance spectra, compared to a non-minimal encoder implmentation. Due to identical generating matrices $\mathbf{G}_{(z)}$, the code implementations do not differ in terms of the specific mapping from input symbols $\mathbf{u}_{(t)}$ to output symbols $\mathbf{y}_{(t)}$. The only, but essential difference, is the size of the state-space $\mathbf{x}_{(t)}$, which uniquely determines the size of the Trellis.

The term *minimal* follows the definition of minimal [**ABCD**]-implementations given in linear system and control theory. It must clearly be distinguished from the term *minimal* basic, which sometimes in coding theory [5] is also referred to as *minimal* in short. In coding theory [5] a generator matrix $\mathbf{G}_{(z)}$ can be separated via polynomial Smith decomposition, into a [$k \times k$] left-hand side matrix $L_{(z)}$, a [$n \times n$] right-hand side matrix $R_{(z)}$ and a [$k \times n$] inner diagonal matrix $D_{(z)}$, such that: $\mathbf{G}_{(z)} = L_{(z)}D_{(z)}R_{(z)}$. If all diagonal elements of $D_{(z)}$ are equal to one, then $\mathbf{G}_{(z)}$ is a non-catastrophic generator matrix. The first $k$ rows of $R_{(z)}$ represent a basic generator matrix $G_{basic(z)} = R_{(1:k;1:n)(z)}$, which produce the same set of codewords as $\mathbf{G}_{(z)}$. Hence the term *basic* means, that $\mathbf{G}_{(z)}$ and $\mathbf{G}_{baisc(z)}$ are not catastrophic. Finally, if one minimizes the basic generator matrix $\mathbf{G}_{basic(z)}$ over the constraint length, a *minimal basic* generator matrix $\mathbf{G}_{minimal\,basic(z)}$ is computed, which does not necessarily offer a *minimal* implementation in the sense of linear system and control theory.

Obviously, Trellis decoding over a minimal code implementation, does not only lead to a reduction of computational complexity due to the lower number of states, but it also leads to an improved decoding performance, especially if soft-decoding is required, as the reduction of states comes along with a reduction of the set of available code words.

In linear control and system theory, a [**ABCD**]-system] implementation is minimal if and only if the system is controllable and observable as defined by the equations 49 and 50:

$$\mathrm{rank}\left\{\mathbf{Q}_{controllability}\right\}\Big|_{\mathbf{GF_2}} \overset{\mathrm{def}}{=} \mathrm{rank}\left\{\left[\begin{array}{ccccc} \mathbf{A}^{(\mu-1)}\mathbf{B}, & \mathbf{A}^{(\mu-2)}\mathbf{B}, & \cdots, & \mathbf{AB}, & \mathbf{B} \end{array}\right]\right\}\Big|_{\mathbf{GF_2}} \overset{!}{=} \mu$$

$$(49)$$

$$\mathrm{rank}\left\{\mathbf{Q}_{observability}\right\}\Big|_{\mathbf{GF_2}} \overset{\mathrm{def}}{=} \mathrm{rank}\left[\begin{array}{c} \mathbf{C} \\ \mathbf{CA} \\ \mathbf{CA^2} \\ \vdots \\ \mathbf{CA}^{(\mu-1)} \end{array}\right]\Bigg|_{\mathbf{GF_2}} \overset{!}{=} \mu. \qquad (50)$$

The meaning of *controllability* and *observability* is easily understood from equation 51. In this context the term *controllability* is used synonymous with the term *reachability*, even though in linear system and control therory [9], they are distinguished. Actually, the condition in equation 49 is necessary and sufficient to ensure *reachability*. From *reachability controllability* always follows, but not vice versa. A *non-reachable* system implementation may still be *controllable* i.e. there may still exist a input sequence $(\mathbf{u}_{(t=0)},..., \mathbf{u}_{(t=\mu-1)})$ that drives the final state into the all zero state $\mathbf{x}_{(t=\mu)} = 0$. With respect to this, equation 49 is a sufficient condition for *controllability*, but its fulfillment is not required.

$$\begin{bmatrix} \mathbf{y}_{(t=0)} \\ \mathbf{y}_{(t=1)} \\ \mathbf{y}_{(t=2)} \\ \mathbf{y}_{(t=3)} \\ \vdots \\ \mathbf{y}_{(t=\mu-1)} \\ \hline \mathbf{x}_{(t=\mu)} \end{bmatrix} = \left[ \begin{array}{cccccc|c} D & & & & & & C \\ CB & D & & & & & CA \\ CAB & CB & D & & & & CA^2 \\ CA^2B & CAB & CB & D & & & CA^3 \\ \vdots & \vdots & \vdots & & \ddots & & \vdots \\ CA^{(\mu-2)}B & CA^{(\mu-3)}B & & \cdots & CB & D & CA^{(\mu-1)} \\ \hline A^{(\mu-1)}B & A^{(\mu-2)}B & & \cdots & AB & B & A^{\mu} \end{array} \right] \begin{bmatrix} \mathbf{u}_{(t=0)} \\ \mathbf{u}_{(t=1)} \\ \mathbf{u}_{(t=2)} \\ \mathbf{u}_{(t=3)} \\ \vdots \\ \mathbf{u}_{(t=\mu-1)} \\ \hline \mathbf{x}_{(t=0)} \end{bmatrix}.$$

$$(51)$$

Equation 51 includes the encoder output sequence ($\mathbf{y}^T_{(t=0)}$, $\mathbf{y}^T_{(t=1)}$,..., $\mathbf{y}^T_{(t=\mu-1)}$) and the actual sucessor state $\mathbf{x}_{(t=\mu)}$ as a function of the initial state $\mathbf{x}_{(t=0)}$ and the encoder input sequnce ($\mathbf{u}^T_{(t=0)}$, $\mathbf{u}^T_{(t=1)}$,..., $\mathbf{u}^T_{(t=\mu-1)}$). It can be verified from equation 51, that if the submatrix $\mathbf{Q}_{controllability}$ has a right-hand pseudo inverse, then a control sequence ($\mathbf{u}^T_{(t=0)}$, $\mathbf{u}^T_{(t=1)}$,..., $\mathbf{u}^T_{(t=\mu-1)}$) can be found, such that every initial state $x_{(t=0)}$ can be transferred into any other state $\mathbf{x}_{(t=\mu)}$ in $\mu$ transition steps. It should be mentioned, that the controllability matrix $\mathbf{Q}_{controllability}$ generally is not square and as such may possess many generalized, right-hand pseudo inverses. As a sufficient condition for such an inverse $\mathbf{Q}_{controllability}$ is required to have full row rank, as described in equation 49.

The product of the observability matrix $\mathbf{Q}_{observability}$ and the initial state $\mathbf{x}_{(t=0)}$ represents a unique additive component, which is added up to the encoder output sequence ($\mathbf{y}^T_{(t=0)}$, $\mathbf{y}^T_{(t=1)}$,..., $\mathbf{y}^T_{(t=\mu-1)}$). One could assume now, that an observation sequence ($\mathbf{y}^T_{(t=0)}$, $\mathbf{y}^T_{(t=1)}$,..., $\mathbf{y}^T_{(t=\mu-1)}$) and the encoder input sequence ($\mathbf{u}^T_{(t=0)}$, $\mathbf{u}^T_{(t=1)}$,..., $\mathbf{u}^T_{(t=\mu-1)}$) are known over $\mu$ steps. Then, the upper, left-hand side matrix is added on both sides of equation 51 leading to equation 52. It should be mentioned that equation 52 has been achieved by using modulo 2 arithmetic.

$$\begin{bmatrix} \mathbf{y}_{(t=0)} \\ \mathbf{y}_{(t=1)} \\ \mathbf{y}_{(t=2)} \\ \vdots \\ \mathbf{y}_{(t=\mu-1)} \end{bmatrix} + \begin{bmatrix} D & & & \\ CB & D & & \\ CAB & CB & D & \\ \vdots & & & \ddots \\ CA^{(\mu-2)}B & & \cdots & CB & D \end{bmatrix} \begin{bmatrix} \mathbf{u}_{(t=0)} \\ \mathbf{u}_{(t=1)} \\ \mathbf{u}_{(t=2)} \\ \vdots \\ \mathbf{u}_{(t=\mu-1)} \end{bmatrix} = \mathbf{Q}_{observability}\mathbf{x}_{(t=0)}.$$

$$(52)$$

Based on equation 52 it can be seen, that the initial state $\mathbf{x}_{(t=0)}$ can uniquely be recovered, if the observability matrix $\mathbf{Q}_{observability}$ has full row rank, as also described in equation 50. Subsequently, a brief example will show the relation between catastrophic generator matrices $\mathbf{G}_{(z)}$ and the corresponding *minimal* [**ABCD**]-system implementation in controller canonical form. Prior to this, in equation 53 the test criterion for catastrophality as invented by Massey-Sain and reprinted in [5], is presented in equation 53. However, this test on catastrophality is limited to non-recursive generator matrices i.e. matrices having feed-forward structure.

$$\gcd_{all\ column\ combinations\ [j]} \left\{ \det \left\{ \mathbf{G}^{[j]}_{(1:k,1:k)(z)} \right\} \text{ with } j = 1, \dots, \binom{n}{k} \right\} = z^{(\text{any integer number} \geq 0)}$$

(53)

Starting from a rate $R$ = 1/2 encoder with octal generator matrix $\mathbf{G}^{serial\ ccf}_{oct}$ = [27,35] the [**ABCD**]-system representation and the polynomial generator matrix $\mathbf{G}_{(z)}$ are given by the equations 54 and 55.

$$\begin{bmatrix} \mathbf{D} & \mathbf{C} \\ \mathbf{B} & \mathbf{A} \end{bmatrix} = \begin{bmatrix} 1 & 0 & 1 & 1 & 1 \\ 1 & 1 & 1 & 0 & 1 \\ \hline 1 & 0 & 0 & 0 & 0 \\ 0 & 1 & 0 & 0 & 0 \\ 0 & 0 & 1 & 0 & 0 \\ 0 & 0 & 0 & 1 & 0 \end{bmatrix}$$

(54)

$$\mathbf{G}_{(z)} = \begin{bmatrix} z^4 + z^3 + z^2 + 1, & z^4 + z^2 + z + 1 \end{bmatrix}; \quad R = 1/2; \quad \mu = 4;$$

(55)

It is easily verified, that the generator matrix in 55 is catastrophic, as its greatest common polynomial divisor equals to gcd(det(.)) = (1 + z). At the same time its corresponding [**ABCD**]-implementation is *minimal* in the sense of equations 49 and 50. Concluding this statement, the minimality condition according to equations 49 and 50 does not implicitly include the test of catastrophality.

Trellis termination is a task, which is strongly related to the controllability of a [**ABCD**]-system representation. It could already be observed from the figures 4 and 5, that for encoder implementations in observer canonical form a more powerful termination algorithm is required, than comparative traditional termination procedures as for instance in the case of non-systematic, feed-forward convolutional codes.

$$\mathbf{x}_{(t=p+\Theta)} = \begin{bmatrix} \mathbf{A}^{(p+\Theta-1)}\mathbf{B}, & \cdots, & \mathbf{A}^{\Theta}\mathbf{B} & \mathbf{A}^{(\Theta-1)}\mathbf{B}, & \cdots, & \mathbf{AB}, & \mathbf{B} \end{bmatrix} \begin{bmatrix} \mathbf{u}_{(t=0)} \\ \vdots \\ \mathbf{u}_{(t=p-1)} \\ \hline \mathbf{u}_{(t=p)} \\ \vdots \\ \mathbf{u}_{(t=p+\Theta-2)} \\ \mathbf{u}_{(t=p+\Theta-1)} \end{bmatrix}$$

$$+ \mathbf{A}^{(p+\Theta)}\mathbf{x}_{(t=0)}$$

(56)

As a starting point, the sequel of state sequences, as depicted in figure 6 will mathematically be described via the equations 56 and 57, which include an information part ($\mathbf{u}^T_{(t=0)}, \dots, \mathbf{u}^T_{(t=p\text{-}10)}$) and a termination part ($\mathbf{u}^T_{(t=p)}, \dots,$

$$\mathbf{u}^T_{(p+\theta\text{-}1)})..$$

$$\mathbf{x}_{(t=p+\Theta)} = \underbrace{\left[\begin{array}{cccc} \mathbf{A}^{(\Theta-1)}\mathbf{B}, & \cdots, & \mathbf{AB}, & \mathbf{B} \end{array}\right]}_{\overset{def}{=}\mathbf{Q}_{termination}} \begin{bmatrix} \mathbf{u}_{(t=p)} \\ \vdots \\ \mathbf{u}_{(t=p+\Theta-2)} \\ \mathbf{u}_{(t=p+\Theta-1)} \end{bmatrix} + \mathbf{A}^\Theta \mathbf{x}_{(t=p)} \qquad (57)$$

It should be pointed out, that $Q_{termination}$ in equation 57 has the same structure as the controllability matrix $Q_{controllability}$ in equation 49, except that the meaning of the parameters $\mu$ and $\Theta$ is different. Whereas the paramter $\mu$ determines the number of memory elements, the parameter $\Theta$ with $\Theta \leq \mu$ is defined as the shortest number of steps through the Trellis, required to drive the encoder state from any arbitrary state $x_{(t=p)}$ into the zero state $x_{(t=p+\Theta)} = 0$. A sufficient condition herefore is:

$$\Theta = \min_{\tilde{\Theta}=1,...,\mu} \left\{ \tilde{\Theta}, \text{ such that } \text{rank} \left\{ \left[\begin{array}{cccc} \mathbf{A}^{(\tilde{\Theta}-1)}\mathbf{B}, & \cdots, & \mathbf{AB}, & \mathbf{B} \end{array}\right] \right\} \Big|_{\mathbf{GF_2}} = \mu \right\}. \qquad (58)$$

Equation 58 requires $\mathbf{Q}_{termination}$ to have full row rank $\mu$ i.e. a generalized, right-hand side pseudo inverse $\mathbf{Q}^{(-1)}_{termination}$ must exist, such that the following equation 59 holds.

$$Q_{termination}Q^{(-1)}_{termination} = I_{[\mu\times\mu]} \qquad (59)$$

As $\mathbf{Q}_{termination}$ is a non-square matrix of size $[\mu \times \mu\Theta]$ its inverse $\mathbf{Q}^{(-1)}_{termination}$ is not uniquely defined. Fortunately, the task of Trellis termination does not require a unique termination sequence of states $(\mathbf{x}^T_{(t=p)}),..., \mathbf{x}^T_{(t=p+\Theta-1)}$, $\mathbf{x}^T_{(t=p+\Theta)} = 0$) and consequently any arbitrary inverse $\mathbf{Q}^{(-1)}_{termination}$ could be used. It is worth mentioning, that the famous Moore-Penrose inverse, which is an unique inverse, does not always exist, when using binary elements over the $\mathbf{GF_2}$. Hence, in contrast to *unique* pseudo inverses, the pseudo inverse of interest $\mathbf{Q}^{(-1)}_{termination}$ is addressed as *generalized* pseudo inverse. Here, $\mathbf{I}_{[\mu\times\mu]}$ is the identity matrix of size $[\mu\times\mu]$. The generalized right-hand side pseudo inverse can effeciently be computed by extending the row-column substitution algorithm as presented in [7] to non-square matrices. The excellent computational efficiency of this inversion algorithm is mainly given due to the substitution of row and column indices, rather than operating with complex-valued matrix adjugates. Moreover as the inversion algorithm operates with binary elements over $\mathbf{GF_2}$ pivotisation and multiplications become trivial. Using equations 57, 58 and 59, it is easily verified, that the encoder input sequence $(\mathbf{u}^T_{(t=p)},..., \mathbf{u}^T_{(t=p+\theta-1)})$ which generally terminates the Trellis in the state $\mathbf{x}_{(t=p+\theta)}$ is

$$\begin{bmatrix} \mathbf{u}_{(t=p)} \\ \vdots \\ \mathbf{u}_{(t=p+\Theta-2)} \\ \mathbf{u}_{(t=p+\Theta-1)} \end{bmatrix} = \mathbf{Q}^{(-1)}_{termination} \left[ \mathbf{x}_{(t=p+\theta)} - \mathbf{A}^\theta \mathbf{x}_{(t=p)} \right] \qquad (60)$$

and by using modulo 2 arithmetic and defining $\mathbf{x}_{(t=p+\theta)} = 0$ it follows:

$$
\begin{bmatrix}
\mathbf{u}_{(t=p)} \\
\vdots \\
\mathbf{u}_{(t=p+\Theta-2)} \\
\mathbf{u}_{(t=p+\Theta-1)}
\end{bmatrix}
= \mathbf{Q}_{termination}^{(-1)} \mathbf{A}^{\theta} \mathbf{x}_{(t=p)}.
\tag{61}
$$

The termination sequence ($\mathbf{u}_{(t=p)}^{T} ... \mathbf{u}_{(t=p+\theta-1)}^{T}$) as computed by equation 60 and its derivative from 61 for the $GF_2$ is not restricted to [**ABCD**]-encoder implementations in controller canonical form. This termination rule terminates any linear code, which fulfills equation 58, and - in the present context - is applied especially for recursive systematic convolutional codes in observer canonical form.

**Soft-decoding metrics and computational complexity**

The focus of the present section is directed to finding the optimum soft-decision metrics for rate $R = k/n$ convolutional codes and the computational complexity of the corresponding Max-Log-MAP and Log-MAP algorithms. In a first step it will generally be demonstrated, that the structure of rate $R = k/n$ convolutional codes offer limited observability i.e. correspondingly the observability is limited to input symbols $u_{(t)}$, rather than to input bits. In the context of Log-MAP soft-decoding, which is a probabilistic approach of recovering $k$-ary input symbols, it will be proved that only symbol-probabilities i.e. the joint probabilty of all $k$ bits per symbol can be computed precisely. Naturally, if rate $R = k/n$ codes are used in parallel or serial code concatenation schemes, bit-metrics are of significant importance for the decoding performance. Hence, in a second step an appropriate mapping from symbol-metrics to bit-metrics will be presented for the Log-MAP algorithm. It is worthwhile to mention, that in the case of Max-Log-MAP soft-decoding, a mapping from symbol-metrics to bit-metrics is not required. The reason for this is, that even though the Max-Log-MAP is often considered to be an approximation, which maximizes the a-posteriori probabilities of the *code and information symbols*, regardless whether the recovered information sequence does also correspond to a continuous *code sequence* in the Trellis or not. Appropriate bit metrics for the Max-Log-MAP and the Log-MAP algorithm will be presented. In the case of rate $R = k/n$ convolutional codes with $k > 1$ it is an unappropriate simplification to consider the Max-Log-MAP as approximation of the Log-MAP algorithm. It can be shown, that already for codes with moderate memory elements $\mu$, the *native* bit metrics used for the Max-Log-MAP will not work any more for the Log-MAP algorithm, unless they are not adopted to symbol-by-symbol detection. This proves, that generally the Max-Log-MAP for rate $R = k/n$ codes is not an approximation of the Log-MAP. of the Log-MAP algorithm, their behaviour is completely different. The Max-Log-MAP algorithm is defined as a *maximum likelihood sequence estimation* procedure, which might also use a-priori information of the transmitted input bits. As such the Max-Log-MAP computes the most probable *sequence* of *code and information bits.* Alternatively, the Log-MAP algorithm is a *maximum-a-posteriori symbol estimaton procedure*

To demonstrate generally, that rate $R = k/n$ convolutional codes restrict the observability of states or equivalently limit the observability of information bits, a brief discussion is presented, which allows to interpret any rate $R = k/n$ codes as a *shortened* or a *punctured* rate $R = 1/n$ convolutional code. In this context the term *shortened* is preferred, in order to emphasize that the code sequence is rather shortened in a systematic manner, than punctured randomly. To be precise, the rate $R = 1/n$ code is shortened such that, for each block of $kn$ bits the first $(k - 1)n$ bits are left away. As a result, this shortening procedure leads to the same mapping of input-output sequences as the corresponding rate $R = k/n$ code. Moreover, the Trellis structure of the original $R = k/n$ code is extended by $(k - 1)$ memory elements towards a Trellis structure of rate $R = 1/n$. This would, from a theoretical point of view, enable the computation of bit metrics for the information bits, because for each state transition between two known states $x_{(t=p)}$ and $x_{(t=p+1)}$ a unique bit is assigned in the Trellis. However, to *know* a state transition in mathematical terms means, that the state sequence is observable in the sense of linear control and system theory, as demanded by equation 52 and the observability criterion in equation 50. Clearly, shortened rate $R = 1/n$ codes violate the observability criterion from equation 50 and therefore do not allow to directly reconstruct single bits from the received code sequence. For rate $R = k/n$ codes the fulfillment of the observability criterion according to equation 50 means, that the bits assigned to a known state transition can be reconstructed only jointly i.e. as a k-ary symbol $u_{(t)}$.

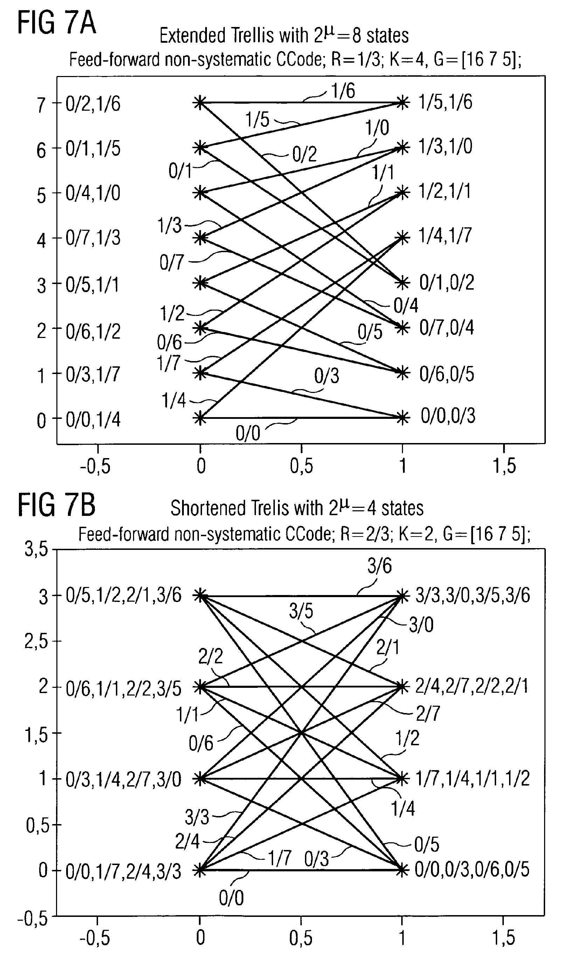

In the following, equations 62 and 63 present an example code of rate $R = 2/3$ and memory $\mu = 2$, which is extended to an rate $R = 1/3$ code, with the corresponding Trellis representations shown in the figures 7(a) and 7(b).

$$R = 2/3; \quad \mu = 2; \quad \mathbf{G}_{oct}^{serial\ ccf} = [16, 7, 5]; \quad \Rightarrow \quad \left[ \begin{array}{c|c} \mathbf{D} & \mathbf{C} \\ \hline \mathbf{B} & \mathbf{A} \end{array} \right] = \left[ \begin{array}{cc|cc} 1 & 1 & 1 & 0 \\ 0 & 1 & 1 & 1 \\ 0 & 1 & 0 & 1 \\ \hline 1 & 0 & 0 & 0 \\ 0 & 1 & 0 & 0 \end{array} \right] \quad (62)$$

$$R = 1/3; \quad \mu = 3; \quad \mathbf{G}_{oct}^{serial\ ccf} = [16, 7, 5]; \quad \Rightarrow \quad \left[ \begin{array}{c|c} \mathbf{D} & \mathbf{C} \\ \hline \mathbf{B} & \mathbf{A} \end{array} \right] = \left[ \begin{array}{c|ccc} 1 & 1 & 1 & 0 \\ 0 & 1 & 1 & 1 \\ 0 & 1 & 0 & 1 \\ \hline 1 & 0 & 0 & 0 \\ 0 & 1 & 0 & 0 \\ 0 & 0 & 1 & 0 \end{array} \right] \quad (63)$$

Based on the [**ABCD**]-system implementation given in the equations 62 and 63 the observability matrices are presented in equations 64 and 65 having full row rank, as they address the full, unshortened codes. Shortening the first $(k - 1)n$ bits of each block of $kn$ bits at the encoder output, is equivalent to removing the first $(k - 1)n$ rows of each block of $kn$ rows in the observability matrix $Q_{observability}$. For the present example depicted in figure 7(a), equation 66 shows clearly, that the observability criterion does not hold for the shortened code.

$$R = 2/3; \quad \mu = 2; \quad \Rightarrow \text{rank} \left\{ \mathbf{Q}_{observability} \right\} \Big|_{\mathbf{GF_2}} = \text{rank} \left\{ \left[ \begin{array}{cc} 1 & 0 \\ 1 & 1 \\ 0 & 1 \\ 0 & 0 \\ 0 & 0 \\ 0 & 0 \end{array} \right] \right\} \Big|_{\mathbf{GF_2}} = 2. \quad (64)$$

$$R = 1/3; \quad \mu = 3; \quad \Rightarrow \text{rank} \left\{ \mathbf{Q}_{observability} \right\}\big|_{\mathbf{GF_2}} = \text{rank} \left\{ \begin{bmatrix} 1 & 1 & 0 \\ 1 & 1 & 1 \\ 1 & 0 & 1 \\ 1 & 0 & 0 \\ 1 & 1 & 0 \\ 0 & 1 & 0 \\ 0 & 0 & 0 \\ 1 & 0 & 0 \\ 1 & 0 & 0 \end{bmatrix} \right\}\Bigg|_{\mathbf{GF_2}} = 3. \quad (65)$$

$$R^{shortened} = 1/3; \quad \mu = 3; \Rightarrow \quad \text{rank} \left\{ \mathbf{Q}_{observability}^{shortened} \right\}\big|_{\mathbf{GF_2}} = \quad \text{rank} \left\{ \begin{bmatrix} 1 & 0 & 0 \\ 1 & 1 & 0 \\ 0 & 1 & 0 \end{bmatrix} \right\}\Bigg|_{\mathbf{GF_2}} \neq 3.$$
$$(66)$$

Generally, it is known from linear control and system theory [9] that, given the initial state $x_{(t)}$, a sufficiently large observation period ($\mathbf{y}_{(t)}$, $\mathbf{y}_{(t+1)}$,..., $\mathbf{y}_{(t+\Theta)}$) and given a proper termination of the state sequence in $\mathbf{x}_{(t+\Theta+1)}$, only a minimal [**ABCD**]-sytem leads to a fully observable state-sequence. This means, that the state-sequence can be unambiguously reconstructed - analytically or via Trellis sequence estimation - based on the observations. On the contrary, if an encoder implementation is not minimal, it means, that the state-space is not fully observable, and the state-sequence can only partly be reconstructed, or more precisely the estimated state-sequence is not a unique solution. In other words, if a non-minimal encoder implementation is converted into a minimal implementation all non-observable memory elements are ignored, because due to the lack of full observability, they cannot be reconstructed analytically nor properly estimated via Trellis diagram.

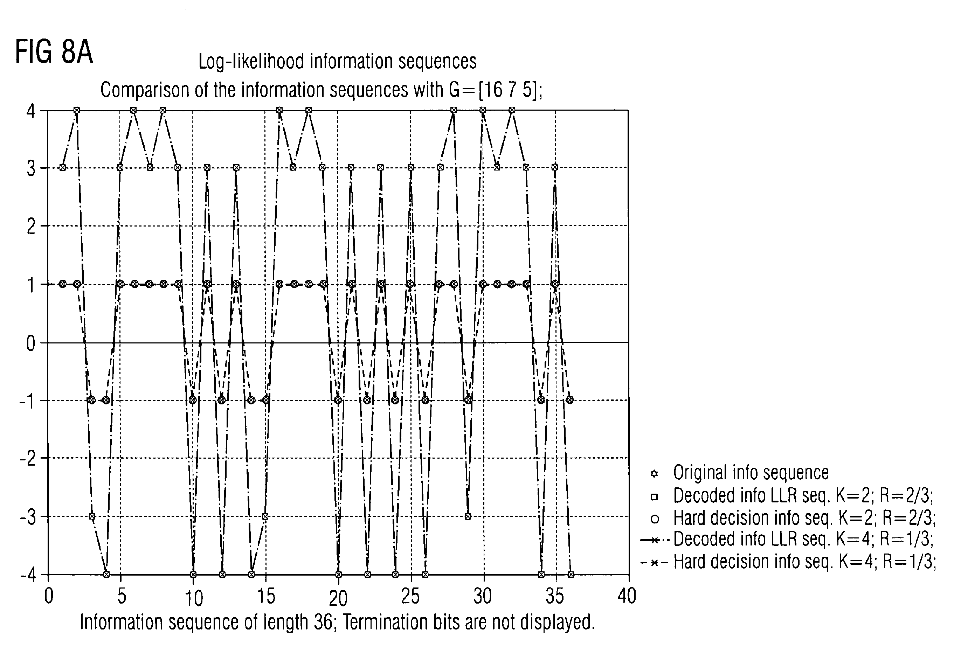

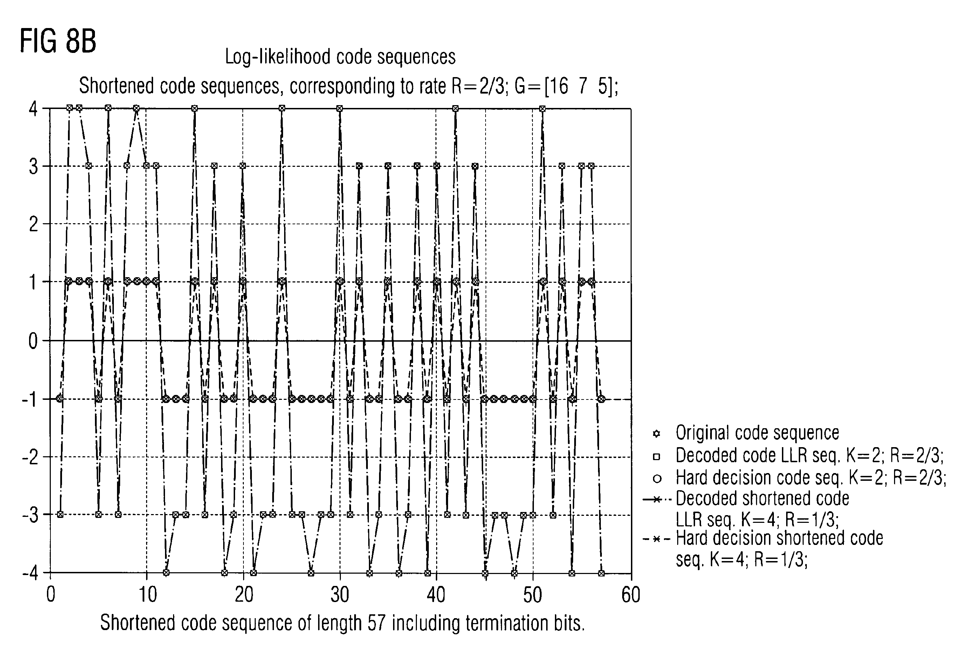

Figure 8 already uses the Max-Log-MAP metrics for rate $R = k/n$ convolutional codes according to table 3, and presents the soft-output metrics for the information and the code sequence at the output of the decoder, for the example given in the equations 62 and 63. In the case of the shortened $R = 1/3$ code according to equation 63, decoding is performed over the full Trellis with $2^\mu = 8$ states, whereby the shortened bits are represented with zero reliability i. e. zero receive power. It can be seen from figure 8, that even though decoding is done over the full Trellis, the decoding metrics are identical to those bit metrics, which have been achieved by decoding over the minimal Trellis. This demonstrates the equivalence with respect to the input-output mapping of both Trellis charts from a decoding point of view.

An optimum symbol by symbol decoding algorithm for linear convolutional codes has initially been published by Bahl, Cocke, Jelinek and Raviv in [10], which is shortly addressed as BCJR-algorithm. The original BCJR-algorithm operates in the probability domain maximizing the a-posteriori symbol probabilities and as such is also well known as the maximum a-posteriori algorithm i.e. the MAP algorithm. As MAP processing in the probability domain involves multiplication of probabilities its derivative in the log-likelihood domain is less complex, as mostly all multiplications are turned into additions of log-domain by using the transform formula $\ln\{p_{(.)}\} \rightarrow$ log-domain. In contrast to the MAP algorithm its derivative in the log-likelihood domain is addressed as log-likelihood maximum a-posteriori algorithm i.e. as the Log-MAP algorithm according to table 2. Both, the MAP and the Log-MAP algorithm comprise a forward and a backward recursion, whereby its forward metrics $\alpha$ and its backward metrics $\beta$ represent *state probabilities*.

In the present context the Max-Log-MAP algorithm is used in its original interpretation according to Viterbi [11], where the algorithm offers asymptotically optimum performance of the detected code sequence. The Max-Log-MAP corresponds to a bi-directional Viterbi algorithm computing a forward and a backward path metrics. Survivor paths are tracked implicitly during the computation of the forward metrics $\alpha$ and the backward metrics $\beta$, hence repre-senting *path metrics*.

Assuming Gaussan probability distributions for the decoder input $\hat{y}$ sequence and the a-priori information on

the information sequence $\hat{u}$, the state transition probability $p_{t(\xi \to \tilde{\xi}|\hat{y}, \hat{u})}$ from state $\xi$ to state $\tilde{\xi}$ is given by equation 67 whereas the corresponding transition metric in the log-domain $\tilde{\gamma}_{t(\xi \to \tilde{\xi})}$ is presented in 68. The metric $\tilde{\gamma}_{t(\xi \to \tilde{\xi})}$ in equation 68 can further be simplified by removing all constant terms. The simplified metric $\gamma_{t(\xi \to \tilde{\xi})}$ is given in equation 69.

$$p_{t(\xi \to \tilde{\xi}|\hat{y}, \hat{u})} = \frac{1}{(\sqrt{2\pi}\sigma)^{(n+k)}} \exp\left\{ -\frac{||\hat{y}_t - y_{(\xi \to \tilde{\xi})}||^2 + ||\hat{u}_t - u_{(\xi \to \tilde{\xi})}||^2}{2\sigma^2} \right\} \qquad (67)$$

$$\tilde{\gamma}_{t(\xi \to \tilde{\xi})} = \ln\left\{ p_{t(\xi \to \tilde{\xi}|\hat{y}, \hat{u})} \right\}$$
$$= -\frac{||\hat{y}_t - y_{(\xi \to \tilde{\xi})}||^2 + ||\hat{u}_t - u_{(\xi \to \tilde{\xi})}||^2}{2\sigma^2} - \frac{(n+k)}{2}\ln\{2\pi\sigma^2\} \qquad (68)$$

$$\gamma_{t(\xi \to \tilde{\xi})} = \frac{\hat{y}_t^T y_{(\xi \to \tilde{\xi})} + \hat{u}_t^T u_{(\xi \to \tilde{\xi})}}{\sigma^2} \simeq \ln\left\{ p_{t(\xi \to \tilde{\xi}|\hat{y}, \hat{u})} \right\} \qquad (69)$$

Forward and backward recursion of the Log-MAP and the Max-Log-MAP are summarized in the equations 71, 72, 76, 77 and the corresponding normalization in the equations 73 and 78. Obviously, the Max-Log-MAP procedure differs from the Log-MAP procedure only sligtly, as the summation operator $\Sigma$ is substituted by a maximum operator max{.}. Indeed Jacobi's formula, as presented in equation 70, allows to approximate a sum of exponentials via a maximum operation, assuming that the condition $|v - \kappa| \to \infty$ holds. However, this condition mostly does not hold.

$$\ln\{e^\nu + e^\kappa\} = \max\{\nu, \kappa\} + \ln\{1 + e^{-|\nu-\kappa|}\} \overset{|\nu-\kappa| \to \infty}{\longrightarrow} \max\{\nu, \kappa\} \qquad (70)$$

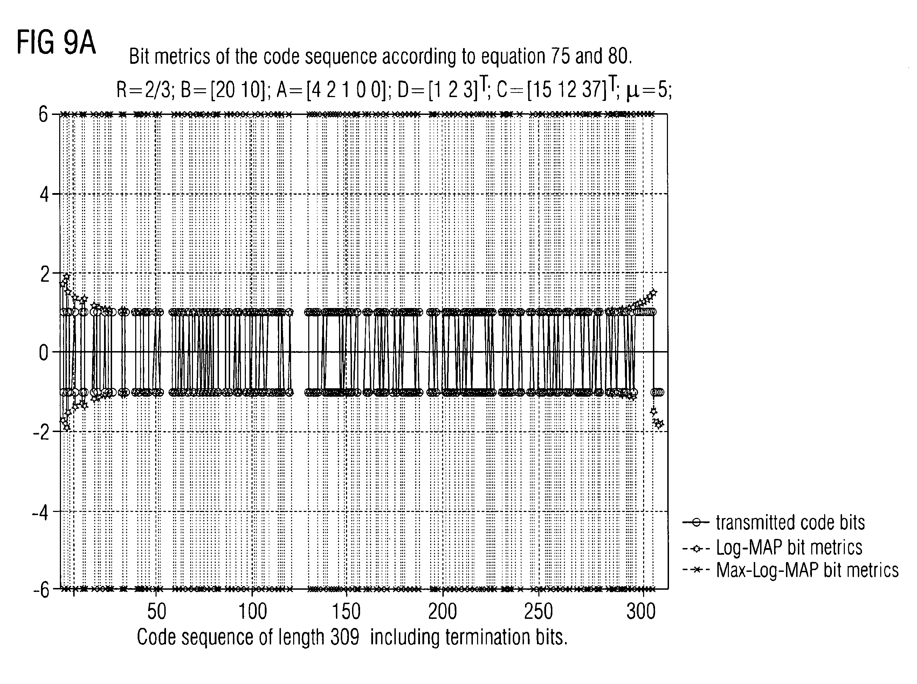

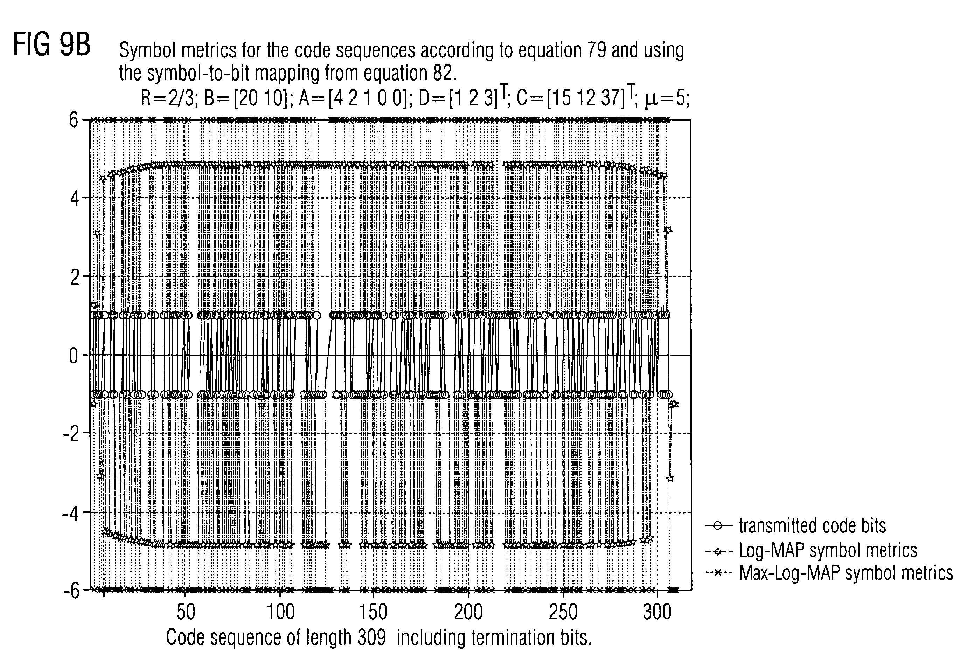

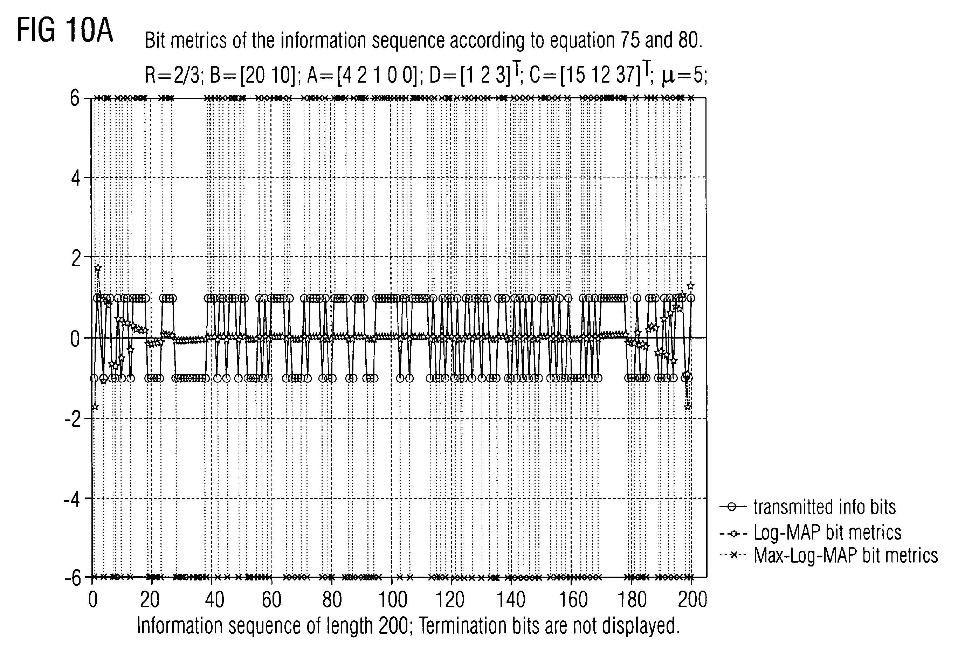

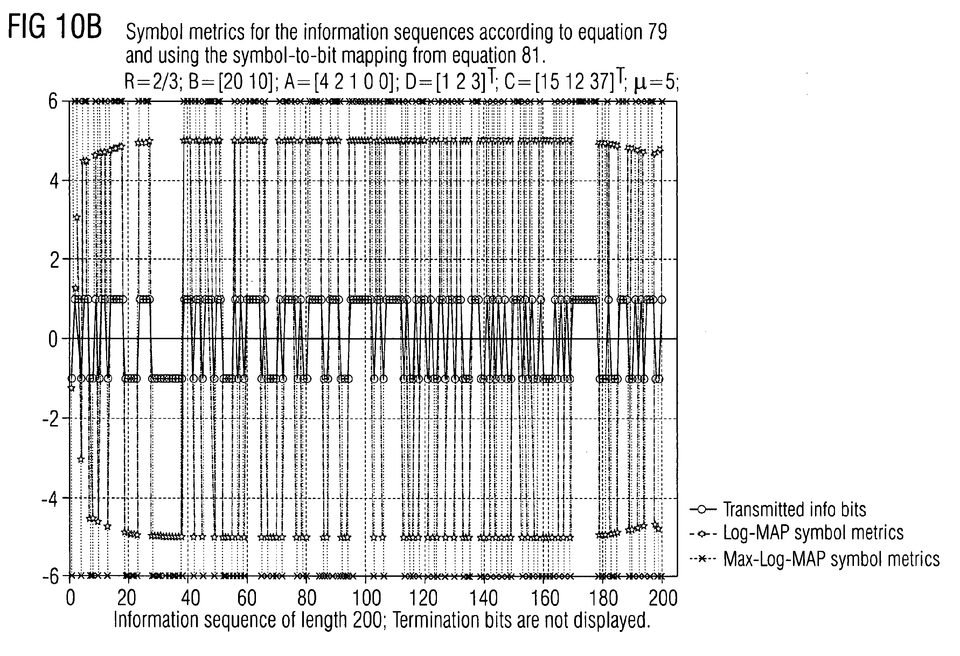

In figure 9 and 10 a rate $R = 2/3$ convolutional code in controller canonical form and with octal generator matrix $\mathbf{G}_{oct}^{serial\ ccf}$ = [132, 224, 376] has been selected to demonstrate the general behavior of symbol and bit metrics for rate $R = k/n$ codes in the context of Log-MAP and Max-Lag-MAP soft decoding. Symbol and bit log-likelihood ratios have been applied according to the equations 74, 79, 75 and 80.

Recalling the former interpretation of rate $R = k/n$ codes as a shortened, rather than punctured, convolutional code of rate $R = 1/n$ that violates the observability criterion of equation 50, any attempt to directly compute log-likelihood ratios on bit level via the Log-MAP algorithm fails, as it can also be seen from the figures 10(a) and 9(a). Comparing the log-likelihood ratio for the Log-MAP algorithm of the decoded code sequence $L_{(y_{\varsigma(t)}|\hat{y}, \hat{u})}$ to the input log-likelihood ratio $L_{(y<(t)}$ as shown in figure 9(a), it can be seen that no extrinsic information is gained, as the figures mostly coincide. The log-likelihood ratios of the information sequence $L_{(u_{\varsigma(t)}|\hat{y}, \hat{u})}$ computed via the Log-MAP algorithm and the bit metric from equation 75 performs even worse. In this case it is seen from figure 10(a), that the log-likelihood ratios $L_{(u_{\varsigma(t)}|\hat{y}, \hat{u})}$ have very low magnitude, as the Log-MAP cannot resolve the ambiguities caused by the code symbols $\mathbf{y}_{(t)}$ which correspond to the same input bit $u_{\zeta(t)}$ of different information symbols $\mathbf{u}_{(t)}$. It is found that only the Max-Log-MAP algorithm is capable of directly computing log-likelihood ratios on bit level. This is because of its essential quality to asymptotically approach optimum sequence estimation with increasing signal to noise ratio.

The Log-MAP algorithm only enables the direct computation of optimum log-likelihood ratios $L_{(u_{\varsigma(t)}=\mathcal{U}|\hat{y}, \hat{u})}$ and $L_{(y_{(t)}=\mathcal{Y}|\hat{y}, \hat{u})}$ on symbol level, according to the equations 74 and 79. Utilizing the symbol metrics from equations 74 and 79 the log-likelihood ratios on bit level can be computed by assigning the symbol-wise log-likelihood ratios to bit-wise log-likelihood ratios in a one-to-one manner:

$$L_{(u_{\varsigma(t)}=+1|\hat{y}, \hat{u})} = L_{(u_{(t)}=\mathcal{U}|\hat{y}, \hat{u})} \quad \text{with } \varsigma = 1, \ldots, k. \qquad (81)$$

$$L_{(y_{\varsigma(t)}=+1\,|\,\hat{\mathbf{y}},\hat{\mathbf{u}})} = \; L_{(\mathbf{y}_{(t)}=\mathcal{Y}\,|\,\hat{\mathbf{y}},\hat{\mathbf{u}})} \quad \text{with } \varsigma = 1,\ldots,n. \tag{82}$$

The log-likelihood ratios on symbol level shown in figures 9(b) amd 10(b) have been computed according to the equations 74 and 79 and have been assigned to log-likelihood ratios on bit level as described by the equations 81 and 82.

The computational complexity of the Log-MAP and the Max-Log-MAP is presented in table 4 based on the algorithms summarized in tables 2 and 3. The complexity measure of interest is the order of magnitude of additions $O_{(additions)}$ required for each state transition in steady state, assuming a rate $R = k/n$ minimal code Trellis with $2^\mu$ states and $2^k$ emerging transitions per state. The term *minimal code Trellis* does not indicate minimal computational complexity, but the minimum number of states. It is worth mentioning, that for *code sets C* of rate $R = k/n$ and ($k > n - k$) a *dual code set* $C^\perp$ of rate $R^\perp = (n - k)/n$ exist, such that only $2^{n-k}$ state transitions emerge per state. Hence, decoding over the dual code may significantly save computational complexity depending on the code rate $R$. Methods to dualize code Trellises have been published in [12,13] and [14]. Unfortunately dualization is not a trivial task and as such does not appear to be ready for implementation yet. Consequently, the complexity figures from table 4 reflect state-of-the-art algorithms, which are ready for implementation. Multiplications of probabilities do not occur in the log-domain as they have been converted into additions of exponentials followed by a logarithm operation ln(.). Hence, additions of exponentials are recursively computed applying Jacobi's formula 70, utilizing one addition, one maximum and one look-up table operation per addition.

**Computation of distance spectra of convolutional codes**

In the present section the method from [8] for computing the Hamming distance spectra of rate $R = 1/n$ convolutional codes will be extended, to general rate $R = k/n$ convolutional codes by taking advantage of the unique state-space description offered by the [**ABCD**]-notation. Additionally, special interest has been directed to the capability of the algorithm to cope with parallel state transitions i.e. parallel branches in the code Trellis.

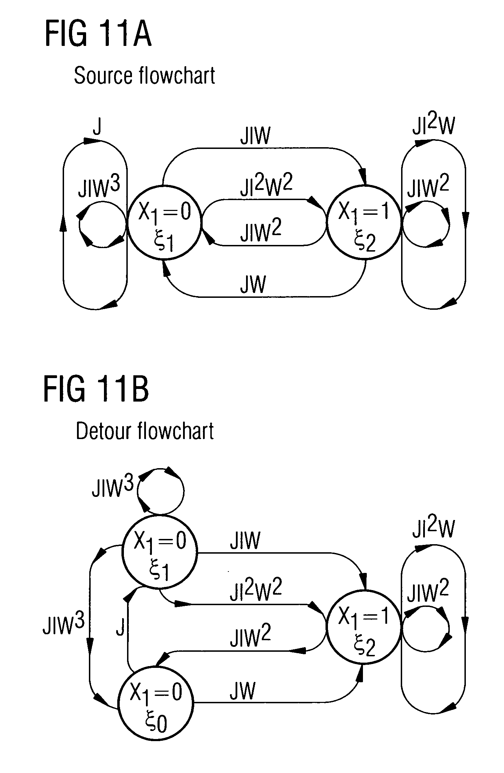

The generalized algorithm is illustrated by the following example, which is a partial-unit-memory (PUM) convolutional code with the generator matrix $\mathbf{G}_{(z)}$ as given by equation 83 and depicted in figure 11(a):

$$\mathbf{G}_{(z)} \quad = \begin{bmatrix} 1 & z & 0 \\ 1 & 1 & 1 \end{bmatrix}; \quad R = 2/3; \quad \mu = 1;$$

$$\mathbf{G}_{oct}^{serial\ ccf} \quad = \begin{bmatrix} 14 & 6 & 4 \end{bmatrix}; \quad R = 2/3; \quad \mu = 1;$$

$$\begin{bmatrix} \mathbf{D} & \mathbf{C} \\ \mathbf{B} & \mathbf{A} \end{bmatrix} = \left[\begin{array}{cc|c} 1 & 1 & 0 \\ 0 & 1 & 1 \\ 0 & 1 & 0 \\ \hline 1 & 0 & 0 \end{array}\right] \tag{83}$$

Figure 11(a) presents the source flowchart, which is obtained from the finite state machine of the code, by introducing an arbitrary, but unique labelling $\xi_1,\xi_2,...\xi_{2^\mu}$ for each of all $2^\mu$ possible state vectors **x**. In addition to that, the *output weight enumerator W*, the *input weight enumerator I* and the *state transition enumerator J* are introduced. These weight enumerators are used to compute a complete set of *path enumerators* $\varepsilon_{(X,V,Z)}$, such that the code distance spectra

$$T_{(W,I,J)} = \sum_{\mathcal{X}=d_{free}}^{\infty} \sum_{\mathcal{V}=1}^{\infty} \sum_{\mathcal{Z}=\tilde{\theta}}^{\infty} \mathcal{E}_{(\mathcal{X},\mathcal{V},\mathcal{Z})} W^{\mathcal{X}} I^{\mathcal{V}} J^{\mathcal{Z}} \tag{84}$$

offers a power series, including all possible state transitions. Without loss of generality, the state sequence starts with the initial all zero state with label $\xi_1$ and terminates in the final, all zero state labelled $\xi_0$. Figure 11(b) shows a modified version of figure 11(a), where all state-transitions (i.e. all branches) are directed from the initial state $\xi_1$ to the final state $\xi_0$, which terminates the state-sequence. In order to enable the computation of the distance spectra $T_{(W,I,J)}$ all transitions included in the source flowchart need to be converted into a detour flowchart, where all state transitions are directed from the initial state to the termination state. In other words, by using the example shown in figure 11, the all zero state has to be split up into state label $\xi_1$, where all state transition (with exception to the all zero transition $J$) *emerge* and the state label $\xi_0$, where all state transitions *terminate.* The detour chart can generally be described via a general matrix representation presented by equation 85.

$$\begin{bmatrix} \xi_0 \\ \xi \end{bmatrix} = J \begin{bmatrix} 0 & \mathbf{a}^T \\ \mathbf{b} & \mathcal{H} \end{bmatrix} \begin{bmatrix} \xi_0 \\ \xi \end{bmatrix} \qquad (85)$$

From equation 85 and with $\xi_1 = J\xi_0$, as it can be seen from figure 11(b), without loss of generality the following equations can be derived:

$$\begin{aligned} \xi &= J\mathbf{b}\xi_0 + J\mathcal{H}\xi & &= \mathbf{b}\xi_1 + J\mathcal{H}\xi \\ \Rightarrow \quad \xi &= \left(\mathbf{I}_{[2^\mu \times 2^\mu]} - J\mathcal{H}\right)^{(-1)} \mathbf{b}\xi_1 \\ \Rightarrow \quad \xi_0 &= J\mathbf{a}^T\xi & &= J\mathbf{a}^T \left(\mathbf{I}_{[2^\mu \times 2^\mu]} - J\mathcal{H}\right)^{(-1)} \mathbf{b}\xi_1 \end{aligned} \qquad (86)$$

Using the definition from [8], the closed form representation and the power series expansion of the general distance spectra $T_{(W,I,J)} = \xi_0/\xi_1$ yields:

$$T_{(W,I,J)} = \frac{\xi_0}{\xi_1} = J\mathbf{a}^T \left(\mathbf{I}_{[2^\mu \times 2^\mu]} - J\mathcal{H}\right)^{(-1)} \mathbf{b} \overset{Geometric\ series}{=} \sum_{p=0}^{p_{max} \to \infty} J^{(1+p)}\mathbf{a}^T\mathcal{H}^p\mathbf{b} \qquad (87)$$

The second half of equation 87 is derived by using the geometric series of matrices according to the equations 88 and 89. It should be mentioned, that the iterative computation of $T_{(W,I,J)}$ is based on equation 89, which holds only if the magnitude of all eigenvalues $\lambda_q$ of the matrix $H$ are smaller than one, thus enforcing convergence of the term $H^{Pmax \to \infty} = 0$. Typically the eigenvalues $\lambda_q$ are polynoimals in $W$ and $I$ by definition i.e. $|\lambda_q| \overset{def}{=} |\lambda_{i(W,I)}|$. This poses new difficulties to show in which cases the convergence condition $|\lambda_{i(W,I)}| < 1$ holds. To iteratively compute the first terms of the distance spectra $T_{(W,I,J)}$ it is not necessary to analyze the eigenvalues $\lambda_q$ but to ensure converge of equation 87.

$$\sum_{p=0}^{p_{max}} \mathcal{H}^p = \left(\mathbf{I}_{[2^\mu \times 2^\mu]} - \mathcal{H}\right)^{(-1)} \left(\mathbf{I}_{[2^\mu \times 2^\mu]} - \mathcal{H}^{(p_{max}+1)}\right) \qquad (88)$$

$$\sum_{p=0}^{p_{max} \to \infty} \mathcal{H}^p \overset{|\lambda_q|<1\ \forall\ eigenvalues\ of\ \mathcal{H}}{=} \left(\mathbf{I}_{[2^\mu \times 2^\mu]} - \mathcal{H}\right)^{(-1)} \qquad (89)$$

Due to completeness, the distance spectra of the PUM-code from figure 11 is computed accordingly to equation 91 by using the matrix representation of the detour flowchart as given in equation 90.

$$\begin{bmatrix} \xi_0 \\ \xi_1 \\ \xi_2 \end{bmatrix} = J \left[ \begin{array}{c|cc} 0 & IW^3 & W + IW^2 \\ \hline 1 & IW^3 & 0 \\ \hline 0 & IW + I^2W^2 & IW^2 + I^2W \end{array} \right] \begin{bmatrix} \xi_0 \\ \xi_1 \\ \xi_2 \end{bmatrix} \qquad (90)$$

$$T_{(W,I,J)} = J\mathbf{a}^T \left( \mathbf{I}_{[2^\mu \times 2^\mu]} - J\mathcal{H} \right)^{(-1)} \mathbf{b} = -\frac{JIW^2 \left(-W + JIW^3 - J - 2\,JIW\right)}{\left(-1 + JIW^3\right)\left(-1 + JIW^2 + JI^2W\right)} \qquad (91)$$

To validate the procedure defined by the equations 85 and 87 with respect to its capability, to determine the weight enumerators in the presence of parallel state transitions, the results of the proposed algorithm have been compared to results given in [6]. Naturally the distance spectra components summarized in table 5 are identical to those in [6].

The computational complexity of the symbolic matrix inverse $(\mathbf{I}_{[2^\mu \times 2^\mu]} - JH)^{(-1)}$ in equation 87 is a fundamental limitation, which renders the computation of $T_{(W,I,J)}$ impossible, already for encoder implementations with a moderate number of memory elements $\mu$. This limitation can basically be overcome by turning the matrix inverse into a power series of the matrix $H$ according to the right-hand side of equation 87. A more practical and efficient representation of the power series of the distance spectra $T_{(W,I,J)}$ is achived when using the Cayley-Hamilton theorem, which is presented in equation 92.

$$F_{(H)} = \omega_0 \mathbf{I}_{[2^\mu \times 2^\mu]} + \omega_1 H + ... + \omega_{2^\mu-1} H^{(2^\mu-1)} + H^{2^\mu} = 0 \qquad (92)$$

According to the Cayley-Hamilton theorem the matrix $H$ fulfills its own characteristic polynomial $F_{(\lambda)}$, such that $F_{(H)} = 0$ holds. The coefficients $[\omega_0, \omega_1, ..., \omega_{2^\mu-1}]$ are polynomials in W and I (but not in J), which can easily be computed from the the characteristic polynomial, which is presented in equation 93.

$$F_{(\lambda)} = \det(\lambda\, \mathbf{I}_{[2^\mu \times 2^\mu]} - H) = \omega_0 + \omega_1 \lambda + ... + \omega_{2^\mu-1} \lambda^{(2^\mu-1)} + \lambda^{2^\mu} \qquad (93)$$

It follows, that any exponential term $H^p$ can be computed iteratively by multiplying $H^{(p-2^\mu)}$ to both sides of equation 92 and reshaping equation 92, which leads to the follwing equation:

$$H^p = -\,(\omega_0 H^{(p-2^\mu)} + \omega_1 H^{(p-2^\mu+1)} + ... + \omega_{2^\mu-1} H^{(p-1)})\ \text{for all } p \geq 2^\mu. \qquad (94)$$

Matrix recursions in the form of equation 94 still suffer from high computational complexity, depending on the dimension of the matrix $H$. To avoid this, a left-hand side multiplication of the vector $\mathbf{a}^T$ and a right-hand side multiplication of the vector $\mathbf{b}$ to equation 94 is computed leading to equation 95.

$$\mathbf{a}^T H^p \mathbf{b} = -\,(\omega_0\, \mathbf{a}^T H^{(p-2^\mu)}\mathbf{b} + \omega_1\, \mathbf{a}^T H^{(p-2^\mu+1)}\mathbf{b} + ... + \omega_{2^\mu-1}\, \mathbf{a}^T H^{(p-1)}\mathbf{b})\ \text{for all } p \geq 2^\mu. \qquad (95)$$

After the introduction of the definition $\Omega_p = \mathbf{a}^T H^p \mathbf{b}$, equations 95 can be rewritten as a recursion of scalar polynomials as presented in equation 96.

$$\Omega_p = -\,(\omega_0\, \Omega_{p-2^\mu} + \omega_1\, \Omega_{p-2^\mu+1} + ... + \omega_{2^\mu-1}\, \Omega_{p-1})\ \text{for all } p \geq 2^\mu. \qquad (96)$$

Now it becomes obvious, that the polynomial matrix multiplication of size $[2^\mu \times 2^\mu]$ as suggested by equation 95 and the right-hand side of equation 87 can be replaced by a recursion of scalar polynomials, which for $p \geq 2^\mu$ significantly reduces memory consumption and computational complexity. Inserting the definition $\Omega_p = \mathbf{a}^T H^p \mathbf{b}$ into equation 87 the distance spectra $T_{(W,I,J)}$ can be summarized as follows:

$$T_{(W,I,J)} = \sum_{p=0}^{p_{max} \to \infty} J^{(1+p)} \mathbf{a}^T \mathcal{H}^p \mathbf{b} = \sum_{p=0}^{p_{max} \to \infty} J^{(1+p)} \Omega_p \qquad \text{with} \qquad (97)$$

$$\Omega_p = \begin{cases} \mathbf{\Psi}_p \mathbf{b} \text{ with } \mathbf{\Psi}_p = \begin{cases} \mathbf{a}^T & \text{for} \quad p = 0, \\ \mathbf{\Psi}_{p-1} \mathcal{H}^p & \text{for all} \quad 0 < p < 2^\mu. \end{cases} & \text{for all } 0 \leq p < 2^\mu, \\ \\ - \left( \omega_0 \, \Omega_{p-2^\mu} + \omega_1 \, \Omega_{p-2^\mu+1} + \ldots + \omega_{2^\mu-1} \, \Omega_{p-1} \right) & \text{for all } p \geq 2^\mu. \end{cases}$$

$$(98)$$

If the number of iteration steps $p_{max}$ is high enough and the magnitude of all eigenvalues $\lambda_q$ of the matrix $H$ is smaller than one i.e. the condition $|\lambda_q| < 1$ holds, the weight enumerators $\varepsilon_{(X,V,Z)}$ converge, and hence offer precise values for the lower end of the distance spectra $T_{(W,I,J)}$. Here, the major computational complexity is shifted from a closed form polynomial matrix inversion to the iterative calculation of a power series of polynomial matrices. The most significant reduction of computational complexity is achieved by utilizing the Cayley-Hamilton theorem, which combined with the definition $\Omega_p = \mathbf{a}^T H^p \mathbf{b}$, allows to convert polynomial matrix operations into simple polynomial operations. It is self-evident, that the polynomial components of $\Omega_p$ increase in trems of their polynomial exponent i.e. also in terms of length at every single step $p$. This, depending on the number of iterations $p$, may still set limits to the computation of $\Omega_p$. An additional essential simplification, which does not reduce accuracy of the weight enumerators of interest, is introduced as described in equation 99:

$$\tilde{\Omega}_p = \left\lceil \Omega_p \right\rceil_{polynomial}^{remove \ all \ W^{\mathcal{X} > \mathcal{X}_{max}}} \quad \text{and} \quad \tilde{\mathbf{\Psi}}_\mathbf{p} = \left\lceil \mathbf{\Psi}_\mathbf{p} \right\rceil_{polynomial}^{remove \ all \ W^{\mathcal{X} > \mathcal{X}_{max}}} \qquad (99)$$

The operator $\lceil . \rceil_{polynomial}^{remove \ all \ W^{X > X_{max}}}$ denotes the polynomial ceil operator, which removes all polynomial coefficients with respect to the *output weight enumerator* W, whose exponent $\chi$ is higher than a threshold $\chi_{max}$. Typically, the threshold $\chi_{max}$ is chosen sligthly higher than the minimum free distance $d_{free}$ i.e. $(\chi_{max} > d_{free})$ and the number of iterations $p_{max}$ is adjusted such that, the set of weight enumerators $\{\varepsilon_{(\chi=d_{free},V,Z)}, \ldots, \varepsilon_{(\chi \leq \chi_{max}, V, Z)}\}$ converges. As a result the algorithm presented in the equations 97 and 98 combined with the modification given in equation 99 significantly extends its applicability towards code implementations with higher memory elements $\mu$, compared to the original formulations of equation 87. Its main advantage is that the computational complexity is significantly reduced, without losing accuracy of the weight enumerators at the lower end of the distance spectra. Naturally, removing the *input weight enumerator I* and the *transition weight enumerator J* by setting them to one i.e. $I = 1$ and $J = 1$ further reductions of the computational complexity are achieved. However, this simplification also restricts the information content of the full weight enumerators $\varepsilon_{(X,V,Z)}$ to the *output weight enumerator* $\varepsilon_{(X)}$ only, thus also losing information on the code distance spectra.

Generally, the code distance spectra $T_{(W,I,J)}$ according to the right-hand side of equation 87 is interpreted as a *complete set of the path enumerators* $\varepsilon_{(X,V,Z)}$ which count the state transitions in terms of *the input weight enumerator I, the ouput weight enumerator W* and *the state transition enumerator J*. Traditionally, the path enumerator interpretation of $T_{(W,I,J)}$ is linked to the right-hand side of equation 87, which implies that all eigenvalues of the matrix $H$ fulfill the convergence condition $|\lambda_q| < 1$. It is easily verfied, that in those cases where the convergence condition $|\lambda_q| < 1$ holds, the right-hand side of equation 87 equals to the Taylor series expansion of $T_{(W,I,J)}$ at position $W = 0$ of the left-hand side of equation 87. Moreover, in case that the convergence condition $|\lambda_q| < 1$ is fulfilled the path enumerators $\varepsilon_{(X,V,Z)}$

are always positive integer numbers.

In the following, an example of a closed form code distance spectra $T_{(W,I,J)}$ shall be presented for that not all eigenvalues of $H$ fullfill the condition $|\lambda_q| < 1$. Typically, those eigenvalues which cannot be cancelled do also represent singular values of $T_{(W,I,J)}$. Generally the definition in equation 100 leads to the fact that all eigenvalues $J\lambda_q$ become roots of equation 101.

$$T_{(W,I,J)} = J\mathbf{a}^T \left(\mathbf{I}_{[2^\mu \times 2^\mu]} - J\mathcal{H}\right)^{(-1)} \mathbf{b} = J\mathbf{a}^T \frac{\text{adj}\left(\mathbf{I}_{[2^\mu \times 2^\mu]} - J\mathcal{H}\right)^T}{\det\left(\mathbf{I}_{[2^\mu \times 2^\mu]} - J\mathcal{H}\right)} \mathbf{b} \qquad (100)$$

$$\det\left(\mathbf{I}_{[2^\mu \times 2^\mu]} - J\mathcal{H}\right) = \prod_{q=1}^{q_{max} \leq 2^\mu} \left(1 - J\lambda_q\right) \qquad (101)$$

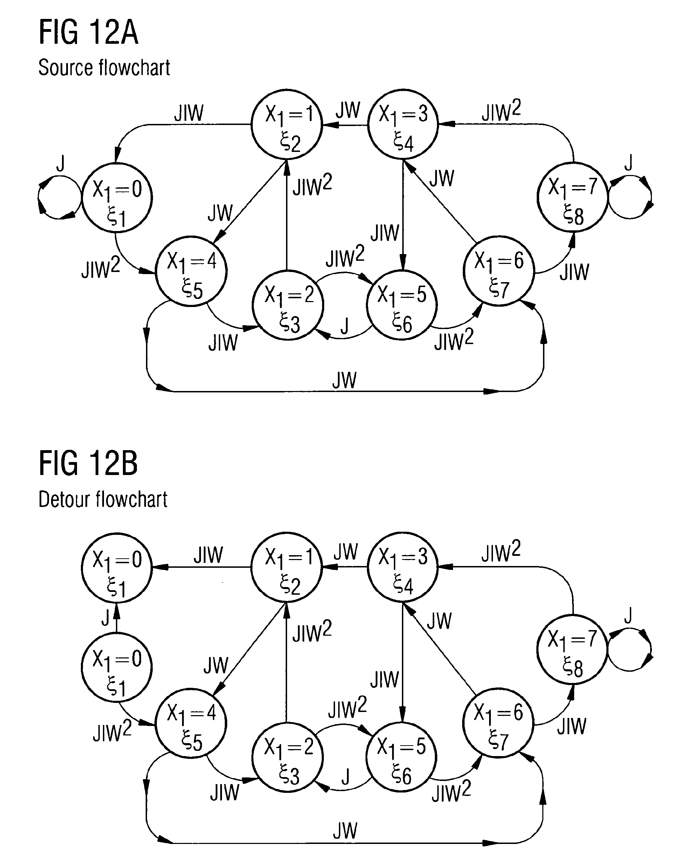

However, only the remaining roots i.e. after cancellation of denominator and the numerator $J\mathbf{a}^T \text{adj}(\mathbf{I}_{[2^\mu \times 2^\mu]}$ $-J\mathcal{H})^T\mathbf{b}$ do also become singular values of $T_{(W,I,J)}$. To be precise, if $\lambda_q$ is an eigenvalue of the matrix $H$ then the eigenvalue $= J\lambda_q$ is a eigenvalue of the matrix $= JH$. However, in the present context the parameter $J$ is set to one i.e. $J = 1$ without loss of generality. Figure 12 shows the source and the detour flowchart of a recursive systematic encoder of rate R = 1/2, memory $\mu = 3$ and with octal matrices $\mathbf{D}_{oct}^T = [1,1]$; $\mathbf{C}_{oct}^T = [0,5]$; $\mathbf{B}_{oct} = [4]$; $\mathbf{A}_{oct} = [6, 5, 4]$. Its binary [ABCD]-representation is given in equation 102.

Staring from the binary [ABCD]-encoder representation according to equation 102 the source flowchart as shown in figure 12(a) is uniquely defined. Based on the source flowchart the detour flowchart as shown in figure 12(b) is derived and the corresponding equation system as presented in equation 103 is set up.

$$[\mathbf{D}|\mathbf{C}] = \begin{bmatrix} 1 & 0 & 0 & 0 \\ 1 & 1 & 0 & 1 \end{bmatrix} \quad [\mathbf{B}|\mathbf{A}] = \begin{bmatrix} 1 & 1 & 1 & 1 \\ 0 & 1 & 0 & 0 \\ 0 & 0 & 1 & 0 \end{bmatrix} \qquad (102)$$

$$
\begin{bmatrix} \xi_0 \\ \xi \end{bmatrix} = J \begin{bmatrix} 0 & \mathbf{a}^T \\ \mathbf{b} & \mathcal{H} \end{bmatrix} \begin{bmatrix} \xi_0 \\ \xi \end{bmatrix}
$$

$$
= J \begin{bmatrix}
0 & 0 & IW & 0 & 0 & 0 & 0 & 0 & 0 \\
1 & 0 & 0 & 0 & 0 & 0 & 0 & 0 & 0 \\
0 & 0 & 0 & IW^2 & W & 0 & 0 & 0 & 0 \\
0 & 0 & 0 & 0 & 0 & IW & 1 & 0 & 0 \\
0 & 0 & 0 & 0 & 0 & 0 & 0 & W & IW^2 \\
0 & IW^2 & W & 0 & 0 & 0 & 0 & 0 & 0 \\
0 & 0 & 0 & 1 & IW & 0 & 0 & 0 & 0 \\
0 & 0 & 0 & 0 & 0 & W & IW^2 & 0 & 0 \\
0 & 0 & 0 & 0 & 0 & 0 & 0 & IW & 1
\end{bmatrix}
\begin{bmatrix} \xi_0 \\ \xi_1 \\ \xi_2 \\ \xi_3 \\ \xi_4 \\ \xi_5 \\ \xi_6 \\ \xi_7 \\ \xi_7 \end{bmatrix}
$$

$$(103)$$

Then, the closed form code distance spectra $T_{(W,I,J)}$ is computed according to equation 104.

$$
T_{(W,I,J)} = J\mathbf{a}^T \left( \mathbf{I}_{[2^\mu \times 2^\mu]} - J\mathcal{H} \right)^{(-1)} \mathbf{b}
$$

$$
= \frac{J^4 I^2 W^6 \left( J^4 W^6 I^6 + \left(-3 J^4 I^4 + J^3 I^4\right) W^4 + \left(-2 J^3 I^2 - J^2 I^2 + 3 J^4 I^2\right) W^2 - J^4 + J^2 + J I^2 - I^2 + J^3 - J\right)}{-J^7 I^6 W^{10} + (3 J - 1) J^6 I^4 W^8 + (2 J^2 + J - 3 J^3 + I^2) J^4 I^2 W^6 + (2 I^2 + J^4 - J^3 - 2 J I^2 + J - J^2) J^3 W^4 - J^3 + J^2 + J - 1}
$$

$$(104)$$

Based on distance spectrum $T_{(W,I,J)}$ from equation 104 the input weight enumerator $I$ and the state transition enumerator $J$ are set to one i.e. $I = 1$, $J = 1$ and the first terms of the Taylor series at position $W = 0$ is computed as shown in equation 105. From equation 105 two singular values $\lambda_{1,2} = \pm i\sqrt{\sqrt{2}-1}$ can be identified, which include negative fractional terms contributing to the path enumerators $\varepsilon_{(X,V,Z)}$.

$$
\Rightarrow T_{(W,I=1,J=1)} = -\frac{W^4\left(W^2-2\right)}{W^4 - 2W^2 - 1} = -\frac{W^4\left(W-\sqrt{2}\right)\left(W+\sqrt{2}\right)}{\left(W-i\sqrt{\sqrt{2}-1}\right)\left(W+i\sqrt{\sqrt{2}-1}\right)\left(W-\sqrt{1+\sqrt{2}}\right)\left(W+\sqrt{1+\sqrt{2}}\right)}
$$

$$
= \underbrace{-W^2 - \frac{\frac{\sqrt{2}-1}{2\sqrt{2}}}{W^2 - \left(1-\sqrt{2}\right)}}_{\text{includes also fractional components with } \mathcal{E}<0} + \underbrace{\frac{-\frac{\sqrt{2}+1}{2\sqrt{2}}}{W^2 - \left(1+\sqrt{2}\right)}}_{\text{fractional components with } \mathcal{E}\geq 0}
$$

$$
= -2W^4 + 5W^6 - 12W^8 + 29W^{10} - 70W^{12} + 169W^{14} + \cdots
$$

$$(105)$$

In the present case the occurence of negative path enumerators does not indicate that the encoder is catastrophic. It is well-known, that systematic encoder cannot have catastrophic behavior. It should further be pointed out, that the [**ABCD**]-representation in equation 102 defines a non-minimal encoder in the sence of linear system and control theory. Non-minimal encoder as such also do not explain negative valued path enumerators. Negative, possibly also fractional, path enumerators $\varepsilon_{(X,V,Z)}$ in the distance spectra $T_{(W,I,J)}$ can be explained with the complex valued sigular values $\lambda_q$. Taylor series expansion of fractional terms that include complex singular values may typically produce also negative coefficients, due to the oscillating behaviour of the complex valued phase. The disadvantage in this case is, that the interpretation of the code distance spectra $T_{(W,I,J)}$ as complete set of path enumerators is limited.

Naturally, a closed form code distance spectra $T_{(W,I,J)}$ according to the left-hand side of equation 87 exists even for eigenvalues $\lambda_q$ which prevent the right-hand side of equation 87 to converge, because for some eigenvalues $\lambda_q$ the convergence condition $|\lambda_q| < 1$ is not fulfilled. Also for these encoders a Taylor series expansion of $T_{(W,I,J)}$ at position $W = 0$ can be computed, which may lead to negative, possibly also fractional coefficients, which sets limits to the path enumerator interpretation of the Taylor series. At this stage it could be observed, that negative coefficients coincide either with a catastrophic encoder or with a non-minimal encoder that has complex valued singular values in the code distance spectra $T_{(W,I,J)}$.

At this stage it is not known, whether non-minimal encoder do always have compex eigenvalues in their distance spectra $T_{(W,I,J)}$. Typically, non-minimal encoders implementations include non-observable states or partly non-observable states, which are also included in the dimension of the state transition matrix $H$ of the encoder. However, those non-observable states cannot uniquely be resolved via the observed sequences of *input weight enumerators I* and *output weight enumerator I*. In other words, the traditional *path enumerators* $\varepsilon_{(X,V,Z)}$ in terms of integer numbers cannot unambiguously be resolved over the state space, which makes it reasonable to obtain path enumerators, which can hardly be interpreted in a vital manner.

| R = 2/5 | $\mu = 2$ | $D = [2; 1; 3; 3; 1]$ $\quad C = [0; 0; 1; 2; 3]$ <br> $B = [2, 3]$ $\qquad A = [1, 1]$ | $G_{oct}^{ccf} = [17, 07, 11, 12, 04]$ | $d_{free} = 6$ |
|---|---|---|---|---|
| | $\mu = 4$ | $D = [2; 1; 3; 1; 3]$ $\quad C = [0; 0; 1; 7; 10]$ <br> $B = [3, 4]$ $\qquad A = [4, 2, 1, 16]$ | $G_{oct}^{ccf} = [27, 71, 52, 65, 57]$ | $d_{free} = 10$ |
| | $\mu = 6$ | $D = [2; 1; 3; 2; 1]$ $\quad C = [0; 0; 1; 47; 42]$ <br> $B = [11, 24]$ $\qquad A = [20, 10, 4, 2, 1, 42]$ | $G_{oct}^{ccf} = \begin{array}{l}[247, 366, 171, \\ 266, 373]\end{array}$ | $d_{free} = 12$ |
| R = 3/5 | $\mu = 3$ | $D = [4; 2; 1; 7; 5]$ $\quad C = [0; 0; 0; 1; 7]$ <br> $B = [6, 3, 4]$ $\qquad A = [2, 1, 3]$ | $G_{oct}^{ccf} = [35, 23, 75, 61, 47]$ | $d_{free} = 5$ |
| R = 2/7 | $\mu = 2$ | $D = [2; 1; 2; 1; 3; 2; 3]$ $\quad C = [0; 0; 1; 3; 2; 0; 0]$ <br> $B = [1, 3]$ $\qquad A = [1, 3]$ | $G_{oct}^{ccf} = \begin{array}{l}[15, 06, 17, 05, \\ 12, 15, 13]\end{array}$ | $d_{free} = 9$ |
| | $\mu = 4$ | $D = [2; 1; 1; 3; 2; 1; 3]$ $\quad C = [0; 0; 1; 7; 2; 4; 11]$ <br> $B = [3, 7]$ $\qquad A = [4, 2, 1, 15]$ | $G_{oct}^{ccf} = \begin{array}{l}[33, 55, 72, 47, \\ 25, 53, 75]\end{array}$ | $d_{free} = 14$ |
| | $\mu = 6$ | $D = [2; 1; 3; 2; 1; 3; 2]$ $\quad C = [0; 0; 1; 15; 24; 76; 20]$ <br> $B = [21, 16]$ $\qquad A = [20, 10, 4, 2, 1, 45]$ | $G_{oct}^{ccf} = \begin{array}{l}[312, 125, 247, \\ 366, 171, 266, 373]\end{array}$ | $d_{free} = 18$ |
| R = 3/7 | $\mu = 3$ | $D = [4; 2; 1; 6; 7; 4; 5]$ $\quad C = [0; 0; 0; 1; 5; 1; 3]$ <br> $B = [3, 1, 4]$ $\qquad A = [2, 1, 6]$ | $G_{oct}^{ccf} = \begin{array}{l}[45, 21, 36, 62, \\ 57, 43, 71]\end{array}$ | $d_{free} = 8$ |
| R = 4/7 | $\mu = 4$ | $D = [10; 4; 2; 1; 14; 6; 15]$ $\quad C = [0; 0; 0; 0; 1; 2; 6]$ <br> $B = [12, 11, 15, 1]$ $\qquad A = [4, 2, 1, 3]$ | $G_{oct}^{ccf} = \begin{array}{l}[130, 067, 237, \\ 274, 156, 255, 337]\end{array}$ | $d_{free} = 6$ |
| R = 3/8 | $\mu = 3$ | $D = [4; 2; 1; 5; 7; 3; 6; 4]$ $\quad C = [0; 0; 0; 1; 7; 7; 7; 4]$ <br> $B = [3, 7, 2]$ $\qquad A = [2, 1, 5]$ | $G_{oct}^{ccf} = \begin{array}{l}[42, 51, 36, 75, \\ 23, 61, 15, 47]\end{array}$ | $d_{free} = 8$ |

Table 1: Recursive systematic codes in observer canonical form and its original, non-systematic code in controller canonical form. $R = k/n$ with $n > k + 1$.

## Log-MAP

| | | |
|---|---|---|
| Forward recursion | $\alpha_{t+1(\tilde{\xi})} = \ln\left\{\sum_{\forall:\,\xi\to\tilde{\xi}} e^{\gamma_{t(\xi\to\tilde{\xi})}+\alpha_{t(\xi)}}\right\}$ $\quad p_{0(\xi=0)}=1 \overset{\alpha=\ln(p)}{\Longrightarrow} \alpha_{0(\xi=0)}=0$ $\quad p_{0(\xi\neq0)}=0 \overset{\alpha=\ln(p)}{\Longrightarrow} \alpha_{0(\xi\neq0)}=-\infty$ | (71) |
| Backward recursion | $\beta_{t(\xi)} = \ln\left\{\sum_{\forall:\,\tilde{\xi}\to\xi} e^{\gamma_{t(\tilde{\xi}\to\xi)}+\beta_{t+1(\tilde{\xi})}}\right\}$ $\quad p_{t_{max}(\tilde{\xi}=0)}=1 \overset{\beta=\ln(p)}{\Longrightarrow} \beta_{t_{max}(\tilde{\xi}=0)}=0$ $\quad p_{t_{max}(\tilde{\xi}\neq0)}=0 \overset{\beta=\ln(p)}{\Longrightarrow} \beta_{t_{max}(\tilde{\xi}\neq0)}=-\infty$ | (72) |
| Normalization | $\alpha_{t(\tilde{\xi})} = \alpha_{t(\tilde{\xi})} - \ln\left\{\sum_{\forall:\,\tilde{\xi}} e^{\alpha_{t(\tilde{\xi})}}\right\} \quad \beta_{t(\xi)} = \beta_{t(\xi)} - \ln\left\{\sum_{\forall:\,\xi} e^{\beta_{t(\xi)}}\right\}$ | (73) |
| Symbol metrics | $L_{(\mathbf{u}_{(t)}=\mathcal{U}\,|\hat{\mathbf{y}},\hat{\mathbf{u}})} = \ln\left\{\frac{p_{(\mathbf{u}_{(t)}=\mathcal{U}\,|\hat{\mathbf{y}},\hat{\mathbf{u}})}}{p_{(\mathbf{u}_{(t)}\neq\mathcal{U}\,|\hat{\mathbf{y}},\hat{\mathbf{u}})}}\right\} = \ln\frac{\sum_{\{(\xi\to\tilde{\xi}):\mathbf{u}_{(t)}=\mathcal{U}\}} e^{\alpha_{t(\xi)}+\gamma_{t(\xi\to\tilde{\xi})}+\beta_{t+1(\tilde{\xi})}}}{\sum_{\{(\xi\to\tilde{\xi}):\mathbf{u}_{(t)}\neq\mathcal{U}\}} e^{\alpha_{t(\xi)}+\gamma_{t(\xi\to\tilde{\xi})}+\beta_{t+1(\tilde{\xi})}}}$ $L_{(\mathbf{y}_{(t)}=\mathcal{Y}\,|\hat{\mathbf{y}},\hat{\mathbf{u}})} = \ln\left\{\frac{p_{(\mathbf{y}_{(t)}=\mathcal{Y}\,|\hat{\mathbf{y}},\hat{\mathbf{u}})}}{p_{(\mathbf{y}_{(t)}\neq\mathcal{Y}\,|\hat{\mathbf{y}},\hat{\mathbf{u}})}}\right\} = \ln\frac{\sum_{\{(\xi\to\tilde{\xi}):\mathbf{y}_{(t)}=\mathcal{Y}\}} e^{\alpha_{t(\xi)}+\gamma_{t(\xi\to\tilde{\xi})}+\beta_{t+1(\tilde{\xi})}}}{\sum_{\{(\xi\to\tilde{\xi}):\mathbf{y}_{(t)}\neq\mathcal{Y}\}} e^{\alpha_{t(\xi)}+\gamma_{t(\xi\to\tilde{\xi})}+\beta_{t+1(\tilde{\xi})}}}$ | (74) |
| Bit metrics | $L_{(u_{\varsigma(t)}=+1\,|\hat{\mathbf{y}},\hat{\mathbf{u}})} = \ln\frac{\sum_{\{(\xi\to\tilde{\xi}):u_{\varsigma(t)}=+1\}} e^{\alpha_{t(\xi)}-\gamma_{t(\xi\to\tilde{\xi})}-\beta_{t+1(\tilde{\xi})}}}{\sum_{\{(\xi\to\tilde{\xi}):u_{\varsigma(t)}=-1\}} e^{\alpha_{t(\xi)}+\gamma_{t(\xi\to\tilde{\xi})}-\beta_{t+1(\tilde{\xi})}}}$ $L_{(y_{\varsigma(t)}=+1\,|\hat{\mathbf{y}},\hat{\mathbf{u}})} = \ln\frac{\sum_{\{(\xi\to\tilde{\xi}):y_{\varsigma(t)}=+1\}} e^{\alpha_{t(\xi)}+\gamma_{t(\xi\to\tilde{\xi})}+\beta_{t+1(\tilde{\xi})}}}{\sum_{\{(\xi\to\tilde{\xi}):y_{\varsigma(t)}=-1\}} e^{\alpha_{t(\xi)}+\gamma_{t(\xi\to\tilde{\xi})}+\beta_{t+1(\tilde{\xi})}}}$ | (75) |

Table 2: Compact summary of the Log-MAP algorithm.

| Max-Log-MAP | |
|---|---|

| Forward recursion | $$\begin{cases} \alpha_{t+1(\tilde{\xi})} = \ln\left\{\max_{\forall:\,\xi\to\tilde{\xi}} e^{\gamma_{t(\xi\to\tilde{\xi})}+\alpha_{t(\xi)}}\right\} = \max_{\forall:\,\xi\to\tilde{\xi}}\left\{\gamma_{t(\xi\to\tilde{\xi})}+\alpha_{t(\xi)}\right\} \\ p_{0(\xi=0)} = 1 \stackrel{\alpha=\ln(p)}{\Longrightarrow} \alpha_{0(\xi=0)} = 0 \\ p_{0(\xi\neq0)} = 0 \stackrel{\alpha=\ln(p)}{\Longrightarrow} \alpha_{0(\xi\neq0)} = -\infty \end{cases}$$ | (76) |
|---|---|---|
| Backward recursion | $$\begin{cases} \beta_{t(\xi)} = \ln\left\{\max_{\forall:\,\tilde{\xi}\to\xi} e^{\gamma_{t(\tilde{\xi}\to\xi)}+\beta_{t+1(\tilde{\xi})}}\right\} = \max_{\forall:\,\tilde{\xi}\to\xi}\left\{\gamma_{t(\tilde{\xi}\to\xi)}+\beta_{t+1(\tilde{\xi})}\right\} \\ p_{t_{max}(\tilde{\xi}=0)} = 1 \stackrel{\beta=\ln(p)}{\Longrightarrow} \beta_{t_{max}(\tilde{\xi}=0)} = 0 \\ p_{t_{max}(\tilde{\xi}\neq0)} = 0 \stackrel{\beta=\ln(p)}{\Longrightarrow} \beta_{t_{max}(\tilde{\xi}\neq0)} = -\infty \end{cases}$$ | (77) |
| Normalization | $$\begin{cases} \alpha_{t(\tilde{\xi})} = \alpha_{t(\tilde{\xi})} - \ln\left\{\max_{\forall:\,\tilde{\xi}} e^{\alpha_{t(\tilde{\xi})}}\right\} = \alpha_{t(\tilde{\xi})} - \max_{\forall:\,\tilde{\xi}}\left\{\alpha_{t(\tilde{\xi})}\right\} \\ \beta_{t(\xi)} = \beta_{t(\xi)} - \ln\left\{\max_{\forall:\,\xi} e^{\beta_{t(\xi)}}\right\} = \beta_{t(\xi)} - \max_{\forall:\,\xi}\left\{\beta_{t(\xi)}\right\} \end{cases}$$ | (78) |
| Symbol metrics | $$\begin{cases} L_{(\mathbf{u}_{(t)}=\mathcal{U}\,|\hat{\mathbf{y}},\hat{\mathbf{u}})} = \ln\left\{\dfrac{p_{(\mathbf{u}_{(t)}=\mathcal{U}\,|\hat{\mathbf{y}},\hat{\mathbf{u}})}}{p_{(\mathbf{u}_{(t)}\neq\mathcal{U}\,|\hat{\mathbf{y}},\hat{\mathbf{u}})}}\right\} = \ln\dfrac{\max_{\{(\xi\to\tilde{\xi}):\mathbf{u}_{(t)}=\mathcal{U}\}} e^{\alpha_{t(\xi)}+\gamma_{t(\xi\to\tilde{\xi})}+\beta_{t+1(\tilde{\xi})}}}{\max_{\{(\xi\to\tilde{\xi}):\mathbf{u}_{(t)}\neq\mathcal{U}\}} e^{\alpha_{t(\xi)}+\gamma_{t(\xi\to\tilde{\xi})}+\beta_{t+1(\tilde{\xi})}}} \\ \qquad = \max_{\{(\xi\to\tilde{\xi}):\mathbf{u}_{(t)}=\mathcal{U}\}}\left\{\alpha_{t(\xi)}+\gamma_{t(\xi\to\tilde{\xi})}+\beta_{t+1(\tilde{\xi})}\right\} - \max_{\{(\xi\to\tilde{\xi}):\mathbf{u}_{(t)}\neq\mathcal{U}\}}\left\{\alpha_{t(\xi)}+\gamma_{t(\xi\to\tilde{\xi})}+\beta_{t+1(\tilde{\xi})}\right\} \\ L_{(\mathbf{y}_{(t)}=\mathcal{Y}\,|\hat{\mathbf{y}},\hat{\mathbf{u}})} = \ln\left\{\dfrac{p_{(\mathbf{y}_{(t)}=\mathcal{Y}\,|\hat{\mathbf{y}},\hat{\mathbf{u}})}}{p_{(\mathbf{y}_{(t)}\neq\mathcal{Y}\,|\hat{\mathbf{y}},\hat{\mathbf{u}})}}\right\} = \ln\dfrac{\max_{\{(\xi\to\tilde{\xi}):\mathbf{y}_{(t)}=\mathcal{Y}\}} e^{\alpha_{t(\xi)}+\gamma_{t(\xi\to\tilde{\xi})}+\beta_{t+1(\tilde{\xi})}}}{\max_{\{(\xi\to\tilde{\xi}):\mathbf{y}_{(t)}\neq\mathcal{Y}\}} e^{\alpha_{t(\xi)}+\gamma_{t(\xi\to\tilde{\xi})}+\beta_{t+1(\tilde{\xi})}}} \\ \qquad = \max_{\{(\xi\to\tilde{\xi}):\mathbf{y}_{(t)}=\mathcal{Y}\}}\left\{\alpha_{t(\xi)}+\gamma_{t(\xi\to\tilde{\xi})}+\beta_{t+1(\tilde{\xi})}\right\} - \max_{\{(\xi\to\tilde{\xi}):\mathbf{y}_{(t)}\neq\mathcal{Y}\}}\left\{\alpha_{t(\xi)}+\gamma_{t(\xi\to\tilde{\xi})}+\beta_{t+1(\tilde{\xi})}\right\} \end{cases}$$ | (79) |
| Bit metrics | $$\begin{cases} L_{(u_{\varsigma(t)}=+1\,|\hat{\mathbf{y}},\hat{\mathbf{u}})} = \ln\dfrac{\max_{\{(\xi\to\tilde{\xi}):u_{\varsigma(t)}=+1\}} e^{\alpha_{t(\xi)}+\gamma_{t(\xi\to\tilde{\xi})}+\beta_{t+1(\tilde{\xi})}}}{\max_{\{(\tilde{\xi}\to\xi):u_{\varsigma(t)}=-1\}} e^{\alpha_{t(\xi)}+\gamma_{t(\xi\to\tilde{\xi})}+\beta_{t+1(\tilde{\xi})}}} = \max_{\{(\xi\to\tilde{\xi}):u_{\varsigma(t)}=+1\}}\left\{\alpha_{t(\xi)}+\gamma_{t(\xi\to\tilde{\xi})}+\beta_{t+1(\tilde{\xi})}\right\} \\ \qquad\qquad - \max_{\{(\xi\to\tilde{\xi}):u_{\varsigma(t)}=-1\}}\left\{\alpha_{t(\xi)}+\gamma_{t(\xi\to\tilde{\xi})}+\beta_{t+1(\tilde{\xi})}\right\} \\ L_{(y_{\varsigma(t)}=+1\,|\hat{\mathbf{y}},\hat{\mathbf{u}})} = \ln\dfrac{\max_{\{(\xi\to\tilde{\xi}):y_{\varsigma(t)}=+1\}} e^{\alpha_{t(\xi)}+\gamma_{t(\xi\to\tilde{\xi})}+\beta_{t+1(\tilde{\xi})}}}{\max_{\{(\tilde{\xi}\to\xi):y_{\varsigma(t)}=-1\}} e^{\alpha_{t(\xi)}+\gamma_{t(\xi\to\tilde{\xi})}+\beta_{t+1(\tilde{\xi})}}} = \max_{\{(\xi\to\tilde{\xi}):y_{\varsigma(t)}=+1\}}\left\{\alpha_{t(\xi)}+\gamma_{t(\xi\to\tilde{\xi})}+\beta_{t+1(\tilde{\xi})}\right\} \\ \qquad\qquad - \max_{\{(\xi\to\tilde{\xi}):y_{\varsigma(t)}=-1\}}\left\{\alpha_{t(\xi)}+\gamma_{t(\xi\to\tilde{\xi})}+\beta_{t+1(\tilde{\xi})}\right\} \end{cases}$$ | (80) |

Table 3: Compact summary of the Max-Log-MAP algorithm.

EP 1 583 246 A1

| Processing step | Log-MAP | Max-Log-MAP |
|---|---|---|
| Metrics $\gamma$ (using Walsh-Haddamard techniques) | $2 \cdot (n+k) \cdot \log_2(n+k)$ additions $\Big\}$ eqn., 69 | $2 \cdot (n+k) \cdot \log_2(n+k)$ additions $\Big\}$ eqn., 69 |
| Forward/backward recursion $\alpha, \beta$ | $2 \cdot 2^{\mu+k}$ additions<br>$2 \cdot 2^{\mu+k}$ max<br>$2 \cdot 2^{\mu+k}$ look-up $\Big\}$ eqns., 71, 72 | $2 \cdot 2^{\mu+k}$ additions<br>$2 \cdot 2^{\mu+k}$ max $\Big\}$ eqns., 76, 77 |
| Normalization $\alpha, \beta$ | $2 \cdot 2^{\mu+1}$ additions<br>$2 \cdot 2^{\mu}$ max<br>$2 \cdot 2^{\mu}$ look-up $\Big\}$ eqn., 73 | $2 \cdot 2^{\mu}$ additions<br>$2 \cdot 2^{\mu}$ max $\Big\}$ eqn., 78 |
| Log-likelihood ratios $L_{(\mathbf{u})}, L_{(\mathbf{y})}$ | $3 \cdot 2^{\mu+k}$ additions<br>$3 \cdot 2^{\mu+k}$ max<br>$3 \cdot 2^{\mu+k}$ look-up $\Big\}$ eqns 74, 81, 82 | $(n+k) \cdot 2^{\mu}$ additions<br>$(n+k) \cdot 2^{\mu+k}$ max $\Big\}$ eqn., 80 |
| Complexity order $\mathcal{O}_{(additions)}$ | $5 \cdot 2^{\mu+k} \;+\; 4 \cdot 2^{\mu}$ $+\; 2 \cdot (n+k) \cdot \log_2(n+k)$ | $2 \cdot 2^{\mu+k} \;+\; [(n+k)+2] \cdot 2^{\mu}$ $+\; 2 \cdot (n+k) \cdot \log_2(n+k)$ |

Table 4: Complexity of the Log-MAP and the Max-Log-MAP algorithm per state transition in steady state for rate $R = k/n$ convolutional codes and $2^{\mu}$ states.

| | | | | | |
|---|---|---|---|---|---|
| R = 6/7 | $\mu = 3$ | $D = [40; 20; 10; 4; 2; 1; 13]$ $C = [0; 0; 0; 0; 0; 0; 1]$ <br> $B = [7, 6, 1, 5, 2, 3]$ $A = [2, 1, 5]$ | $G_{oct}^{ocf} =$ | $[16, 14, 11, 12,$ <br> $17, 15, 13]$ | $12\,W^3 + 124\,W^4 + 1024\,W^5$ |
| | $\mu = 4$ | $D = [40; 20; 10; 4; 2; 1; 77]$ $C = [0; 0; 0; 0; 0; 0; 1]$ <br> $B = [3, 6, 5, 4, 7, 2]$ $A = [4, 2, 1, 11]$ | $G_{oct}^{ocf} =$ | $[25, 37, 31, 33,$ <br> $35, 27, 23]$ | $43\,W^4 + 351\,W^5 + 3273\,W^6$ |
| R = 7/8 | $\mu = 3$ | $D = [100; 40; 20; 10; 4; 2; 1; 177]$ $C = [0; 0; 0; 0; 0; 0; 0; 1]$ <br> $B = [1, 3, 6, 5, 4, 7, 2]$ $A = [2, 1, 5]$ | $G_{oct}^{ocf} =$ | $[11, 15, 07, 01,$ <br> $03, 05, 17, 13]$ | $28\,W^3 + 274\,W^4 + 2456\,W^5$ |
| | $\mu = 4$ | $D = [100; 40; 20; 10; 4; 2; 1; 177]$ $C = [0; 0; 0; 0; 0; 0; 0; 1]$ <br> $B = [1, 3, 5, 6, 7, 4, 2]$ $A = [4, 2, 1, 16]$ | $G_{oct}^{ocf} =$ | $[37, 33, 27, 21, 23,$ <br> $25, 31, 35]$ | $78\,W^4 + 784\,W^5 + 7488\,W^6$ |
| R = 8/9 | $\mu = 3$ | $D = [200; 100; 40; 20; 10; 4; 2; 1; 237]$ $C = [0; 0; 0; 0; 0; 0; 0; 0; 1]$ <br> $B = [7, 5, 7, 4, 3, 5, 6, 1]$ $A = [2, 1, 0]$ | $G_{oct}^{ocf} =$ | $[17, 12, 16, 11, 07,$ <br> $13, 15, 03, 00]$ | $W^2 + 40\,W^3 + 432\,W^4$ |
| | $\mu = 4$ | $D = [200; 100; 40; 20; 10; 4; 2; 1; 355]$ <br> $C = [0; 0; 0; 0; 0; 0; 0; 0; 1]$ <br> $B = [15, 16, 14, 7, 13, 17, 5, 11]$ $A = [4, 2, 1, 0]$ | $G_{oct}^{ocf} =$ | $[33, 35, 31, 16, 27,$ <br> $37, 12, 23, 00]$ | $18\,W^3 + 211\,W^4 + 2496\,W^5$ |
| R = 9/10 | $\mu = 3$ | $D = [400; 200; 100; 40; 20; 10; 4; 2; 1; 661]$ <br> $C = [0; 0; 0; 0; 0; 0; 0; 0; 0; 1]$ <br> $B = [4, 5, 7, 7, 6, 1, 5, 6, 1]$ $A = [2, 1, 3]$ | $G_{oct}^{ocf} =$ | $[17, 15, 16, 11, 13,$ <br> $02, 12, 14, 05, 07]$ | $2\,W^2 + 55\,W^3 + 653\,W^4$ |
| | $\mu = 4$ | $D = [400; 200; 100; 40; 20; 10; 4; 2; 1; 766]$ <br> $C = [0; 0; 0; 0; 0; 0; 0; 0; 0; 1]$ <br> $B = [12, 17, 13, 14, 11, 5, 10, 16, 2]$ $A = [4, 2, 1, 7]$ | $G_{oct}^{ocf} =$ | $[33, 21, 31, 27, 35,$ <br> $12, 37, 23, 04, 17]$ | $21\,W^3 + 293\,W^4 + 3893\,W^5$ |

Table 5: Comparison of distance spectra computation using the rate $R = k/(k+1)$ recursive systematic codes in observer canonical form, as printed in [6].

| | | | |
|---|---|---|---|
| R = 10/11 | $\mu = 3$ | $D = [1000; 400; 200; 100; 40; 20; 10; 4; 2; 1; 267]$<br>$C = [0; 0; 0; 0; 0; 0; 0; 0; 0; 1]$<br>$B = [3, 1, 1, 7, 7, 5, 5, 3, 4, 2]$<br>$A = [2, 1, 6]$ | $G_{oct}^{ocf} = [6, 2, 17, 16, 3, 7, 12, 13, 5, 11, 15]$ | $3W^2 + 81W^3 + 1033W^4$ |
| | $\mu = 4$ | $D = [1000; 400; 200; 100; 40; 20; 10; 4; 2; 1; 1774]$<br>$C = [0; 0; 0; 0; 0; 0; 0; 0; 1]$<br>$B = [11, 13, 14, 15, 12, 10, 17, 16, 3, 5]$<br>$A = [4, 2, 1, 7]$ | $G_{oct}^{ocf} = [35, 31, 27, 25, 33, 37, 21, 23, 6, 12, 17]$ | $24W^3 + 414W^4 + 5807W^5$ |
| R = 11/12 | $\mu = 3$ | $D = [2000; 1000; 400; 200; 100; 40; 20; 10; 4; 2; 1; 3065]$<br>$C = [0; 0; 0; 0; 0; 0; 0; 0; 0; 1]$<br>$B = [4, 5, 7, 1, 1, 3, 2, 7, 3, 2]$<br>$A = [2, 1, 6]$ | $G_{oct}^{ocf} = [5, 7, 12, 16, 2, 17, 13, 4, 3, 6, 11, 15]$ | $4W^2 - 124W^3 + 1667W^4$ |
| | $\mu = 4$ | $D = [2000, 1000, 400, 200, 100, 40, 20, 10, 4, 2, 1, 1766]$<br>$C = [0, 0, 0, 0, 0, 0, 0, 0, 0, 1]$<br>$B = [3, 16, 11, 13, 15, 12, 10, 2, 14, 17, 5]$<br>$A = [4, 2, 1, 5]$ | $G_{oct}^{ocf} = [6, 27, 31, 35, 21, 37, 33, 4, 23, 25, 12, 13]$ | $45W^3 + 731W^4 + 11139W^5$ |
| R = 16/17 | $\mu = 5$ | $D = [100000; 40000; 20000; 10000; 4000; 2000; 1000; 400; 200; 100; 40; 20; 10; 4; 2; 1; 115177]$<br>$C = [0; 0; 0; 0; 0; 0; 0; 0; 0; 0; 0; 0; 0; 0; 0; 0; 1]$<br>$B = [13, 13, 5, 11, 17, 1, 15, 6, 1012, 2, 15, 4, 14, 16]$<br>$A = [10, 4, 2, 1, 34]$ | $G_{oct}^{ocf} = [57, 26, 12, 63, 53, 36, 73, 32, 14, 51, 55, 75, 43, 61, 41, 45, 71]$ | $55W^3 + 1510W^4 + 34404W^5$ |

Table 6: Comparison of distance spectra computation using the rate $R = k/(k + 1)$ recursive systematic codes in observer canonical form, as printed in [6].

**Performance analysis of parallel and serial concatenated convolutional codes**

Recently, especially parallel concatenated coding schemes have been subject of many investigations and due to convenient performance have also been established in different standards [15] and [16]. Subsequently, the structure of the component encoders of the 3GPP and IEEE 802.16ab turbo encoders is analyzed by means of their distance spectra. The overall properties of the turbo encoder and specifically the effective free Hamming distance is computed via iterative Max-Log-MAP decoding.

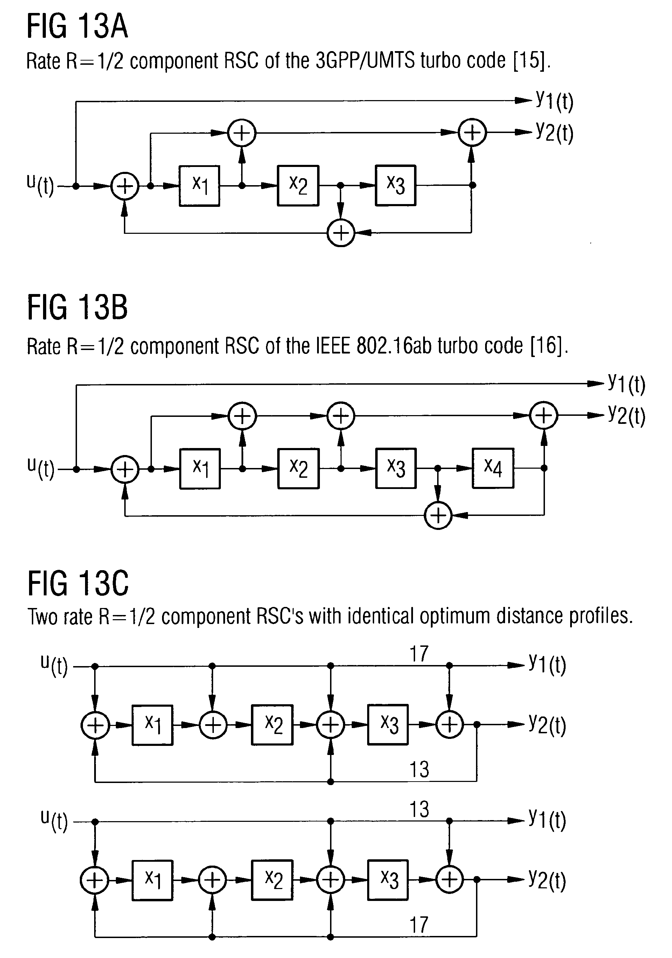

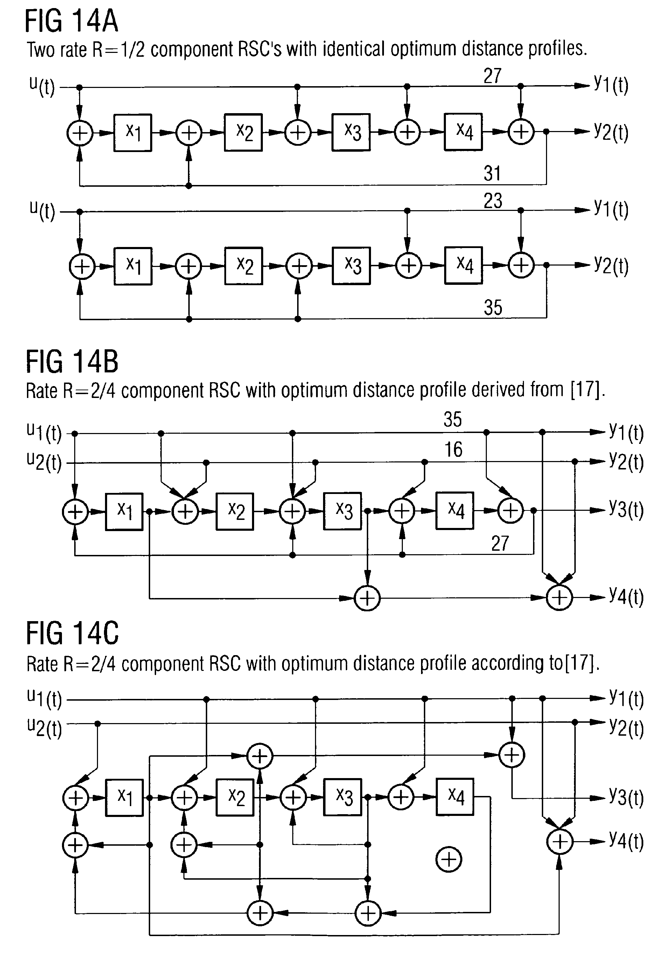

As an additional performance measure, the overall effective free Hamming distance and the statistics of the log-likelihood ratios at the decoder output are analyzed. Figures 13 and 14 present a set of rate $R = 1/2$ and $R = 2/4$ systematic component encoders, leading to an overall turbo encoder rate of $R = 1/3$. As starting point, the most famous component encoders of today, i.e the 3GPP/UMTS and the IEEE 802.16ab turbo code are shown in figures 13(a) and 13(b), respectively. A comparison of the distance spectra $T_{(W)}$ of the 3GPP/UMTS and the IEEE 802.16ab component encoders and their optimal counterparts in figures 13(c) and 14(a), show that coding gains have not been exploited optimally, while using the same amount of computational complexity.

The components encoders shown in figures 14(b) and 14(c) have the same order of computational complexity as the IEEE 802.11ab component encoder from figure 13(b) and slightly higher computational complexity than the component encoder of figure 13(a). In the present context the term computational complexity refers to the total number of mathematical operations over the complete Trellis i.e. over the entire interleaver length. This means, that the order of magnitude of additions $O_{(additions)}$ per state transition step from table 4 must be multiplied by the interleaver length $L_{interleaver}$ and divided by the number of information bits $k$ per state transition leading to:

$$\tilde{\mathcal{O}}_{(additions)} = \mathcal{O}_{(additions)} \cdot \frac{L_{interleaver}}{k} \Rightarrow \frac{\tilde{\mathcal{O}}_{(additions)}}{L_{interleaver}} = \frac{\mathcal{O}_{(additions)}}{k}. \qquad (111)$$

Consequently, even though the order of computational complexity per state transition $O_{(additions)}$ increases exponentially with $k$, the Trellis length at constant information pay-load is reduced linearly by factor $1/k$. This reduces the delay of iterative decoding and causes the total amount of computational complexity to increase more moderately than an exponential increase.

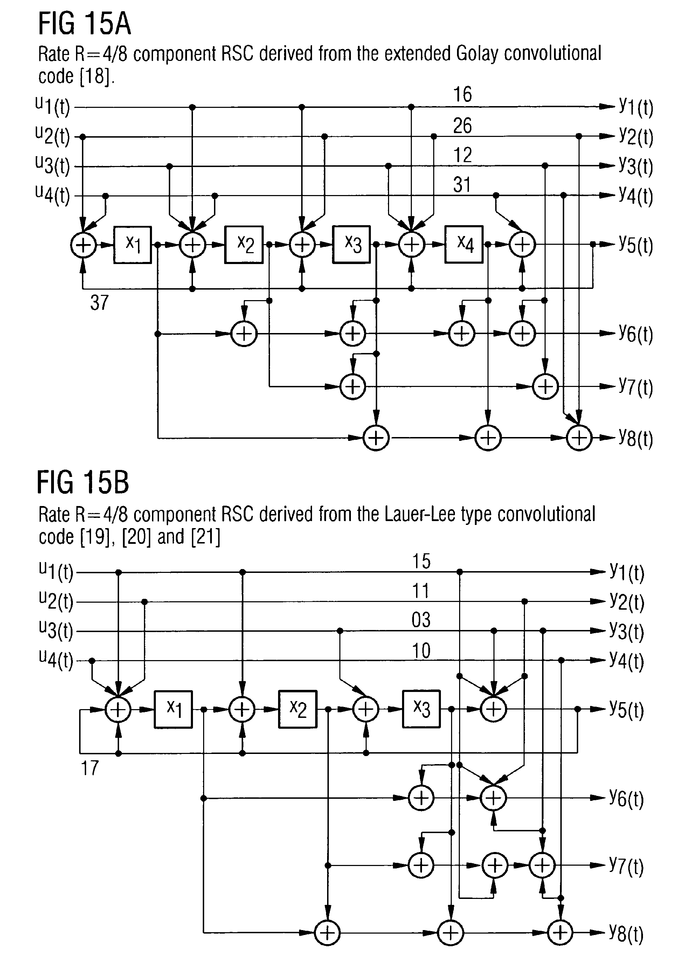

Special interest is also directed to the impact of the minimum free Hamming distance and the convergence properties of different component encoders to the overall turbo encoder. With respect to this, the tables 7 and 8 present a rich set of component encoders all leading to the same overall turbo code rate of $R = 1/3$. Due to different distance spectra $T_{(W)}$, they allow to study the impact of different distance spectra on the overall code. It is worth to mention, that the distance spectra of the rate $R = 2/4$ code depicted in figure 14 and the $R = 4/8$ codes shown in figure 15 meet the Criesmer bound [17] and have a very regular increase of the Hamming weight of the code words.

Table 9 summarizes the effective free distance of the overall turbo code using the component encoders as presented in figure 13 and table 7, and utilizing the 3GPP/UMTS random interleaver as described in [15] for different interleaver lengths $L_{interleaver}$.

It becomes clear from table 9 that the effective free distance of a turbo code not only depends on the free distance of the component code, but also on the dominant distance weight at the lower end of the distance spectra. Comparing the component encoder of rate $R = 2/4$ shown in figure 14(b) and $T_{(W)}$ in equation 110, which is derived from the equivalent feed-forward code representation in [17], with the rate $R = 1/2$ optimum distance code presented in figure 14(a) and $T_{(W)}$ in equation 109, it can be observed that a higher minimum Hamming distance does not necessarily lead to a higher overall effective free distance of the turbo code if the number of code words at the lower end of the distance spectra is high. On the contrary, if the number of code words at the lower end of the distance spetra is comparable, both an improved Hamming weight as well as a lower Hamming weight improves the overall effective free distance of a turbo code, as it becomes obvious from the equation 108, 109 and the equations 106, 107, respectively.

Interestingly, one might ask whether the utilization of different component encoders with identical distance spectra will increase the effective free distance of the overall turbo code. Typically, an increase could not be observed i.e. for the case of of the two rate $R = 1/2$ component encoders from figure 13(c) and equation 107, as well as for the case of the rate $R = 1/2$ encoders from figure 14(a) and equation 109 the overall effective free distance of the code remains the same. For the case of the two rate $R = 2/4$ componenet encoders depicted in the figures 14(b), 14(c) and distance spectra according to equation 110 the overall effective free distance is partly decreasing, depending on the interleaver length, if compared to the the utilization of 14(c) as first and second component encoder.

| | | | | |
|---|---|---|---|---|
| 3GPP: | $R = 1/2;$ $\mu = 3;$ | $T_{(W)} = \dfrac{-W^6\left(W^6 - 4W^4 + 7W^2 - 5\right)}{W^{10} - 4W^8 + 7W^6 - 3W^4 - 4W^2 + 1} =$ | fig., 13(a) | $\begin{cases} D = [1;1]; \\ C = [0;5]; \\ B = [4]; \\ A = [2,5,4]; \end{cases}$ |

$$= \quad 5W^6 + 13W^8 + 71W^{10} + \dots \tag{106}$$

| | | | | |
|---|---|---|---|---|
| Improved 3GPP: | $R = 1/2;$ $\mu = 3;$ | $T_{(W)} = \dfrac{W^6\left(W^2 - W - 1\right)}{W^3 + 2W - 1} =$ | fig., 13(c) upper encoder | $\begin{cases} D = [1;1]; \\ C = [0;1]; \\ B = [2]; \\ A = [2,1,5]; \end{cases}$ |

| | | | | | |
|---|---|---|---|---|---|
| | | $\begin{aligned} =\ & W^6 + 3W^7 + 5W^8 + 11W^9 + \\ & 25W^{10} + 55W^{11} + 121W^{12} + \dots \end{aligned}$ | fig., 13(c) lower encoder | $\begin{cases} D = [1;1]; \\ C = [0;1]; \\ B = [2]; \\ A = [2,1,7]; \end{cases}$ | (107) |

| | | | | | |
|---|---|---|---|---|---|
| IEEE802.16ab: | $R = 1/2;$ $\mu = 4;$ | $\begin{aligned} T_{(W)} =\ & W^6 + 2W^7 + 2W^8 + 10W^9 + \\ & 27W^{10} + 49W^{11} + 99W^{12} + \dots \end{aligned}$ | fig., 13(b) | $\begin{cases} D = [1;1]; \\ C = [0;15]; \\ B = [10]; \\ A = [4,2,11,10]; \end{cases}$ | (108) |

| | | | | | |
|---|---|---|---|---|---|
| Improved IEEE802.16ab: | $R = 1/2;$ $\mu = 4;$ | $\begin{aligned} T_{(W)} =\ & 2W^7 + 3W^8 + 4W^9 + 16W^{10} + \\ & 37W^{11} + 68W^{12} + 176W^{13} + \dots \end{aligned}$ | fig., 14(a) upper encoder | $\begin{cases} D = [1;1]; \\ C = [0;1]; \\ B = [7]; \\ A = [4,2,1,14]; \end{cases}$ | |

| | | | | |
|---|---|---|---|---|
| | | fig., 14(a) lower encoder | $\begin{cases} D = [1;1]; \\ C = [0;1]; \\ B = [7]; \\ A = [4,2,1,16]; \end{cases}$ | (109) |

| | | | | | |
|---|---|---|---|---|---|
| Johannesson & Wittmark | $R = 2/4;$ $\mu = 4;$ | $T_{(W)} = \begin{cases} 12W^8 + 52W^{10} + 260W^{12} + \\ 1483W^{14} + 8070W^{16} + \\ 43389W^{18} + 236331W^{20} + \\ 1283091W^{22} + 6962068W^{24} + \dots \end{cases}$ | fig., 14(b) | $\begin{cases} D = [2;1;2;3]; \\ C = [0;0;14;10]; \\ B = [7,10]; \\ A = [14,16,17,10]; \end{cases}$ | |

| | | | |
|---|---|---|---|
| | | fig., 14(c) | $\begin{cases} D = [2;1;2;3]; \\ C = [0;0;1;12]; \\ B = [5,7]; \\ A = [4,2,1,13]; \end{cases}$ | (110) |

Table 7: Distance spectra of the rate $R = 1/2$ and $R = 2/4$ component encoders from figure 13.

| | | | | | |
|---|---|---|---|---|---|
| $R = 4/8$; <br> $\mu = 3$; | Lauer-Lee type <br> recursive-systematic <br> convolutional code <br> fig., 15(b) | $\left\{\begin{array}{ll} D &= [10;4;2;1; \\ & 16;15;13;7]; \\ C &= [0;0;0;0; \\ & 1;5;3;7]; \\ B &= [1,3,6,4]; \\ A &= [2,1,7]; \end{array}\right.$ | Lauer-Lee type <br> non-systematic <br> convolutional code | $\left\{\begin{array}{ll} D &= [10;14;12;16; \\ & 11;15;13;17]; \\ C &= [7;5;2;4; \\ & 6;3;1;0]; \\ B &= [0,4,2,1]; \\ A &= [0,0,0]; \end{array}\right.$ |

$$T_{(W)} = -\frac{\left(4\,W^6 + 6\,W^4 + 4\,W^2 - 29\right)W^8}{4\,W^{14} + 6\,W^{12} + 4\,W^{10} - W^8 - 4\,W^6 - 6\,W^4 - 4\,W^2 + 1}$$

$$= 29\,W^8 + 112\,W^{10} + 616\,W^{12} + 3248\,W^{14} + 17165\,W^{16} + 90608\,W^{18} + 478408\,W^{20} + \ldots \tag{112}$$

| | | | | | |
|---|---|---|---|---|---|
| $R = 4/8$; <br> $\mu = 4$; | extended Golay <br> recursive-systematic <br> convolutional code <br> fig., 15(a) | $\left\{\begin{array}{ll} D &= [10;4;2;1; \\ & 1;2;12;5]; \\ C &= [0;0;0;0; \\ & 1;17;6;13]; \\ B &= [7,13,5,3]; \\ A &= [4,2,1,17]; \end{array}\right.$ | extended Golay <br> non-systematic <br> convolutional code | $\left\{\begin{array}{ll} D &= [10;14;12;16; \\ & 11;15;13;17]; \\ C &= [7;5;2;4; \\ & 6;3;1;0]; \\ B &= [0,4,2,1]; \\ A &= [0,0,0]; \end{array}\right.$ |

$$T_{(W)} = \frac{W^8\left(-49 + 20\,W^4 + 168\,W^8 + 224\,W^{24} - 448\,W^{20} + 560\,W^{16} - 434\,W^{12} - 64\,W^{28} + 8\,W^{32}\right)}{8\,W^{32} - 48\,W^{28} + 128\,W^{24} - 204\,W^{20} + 204\,W^{16} - 118\,W^{12} + 17\,W^8 + 28\,W^4 - 1}$$

$$= 49\,W^8 + 1352\,W^{12} + 38521\,W^{16} + 1096224\,W^{20} + 31199029\,W^{24} + 887929402\,W^{28} + \ldots \tag{113}$$

Table 8: Distance spectra of rate $R = 4/8$ component encoders from figure 15.

| Interleaver length $L_{interleaver}$ | 3GPP/UMTS Turbo Code $d_{free}$ | Improved 3GPP/UMTS Turbo Code $d_{free}$ | Component RSC according to IEEE 802.16ab $d_{free}$ | Improved component RSC for IEEE 802.16ab $d_{free}$ | Component RSC derived from Johannesson $d_{free}$ |
|---|---|---|---|---|---|
| 40 | 12 | 16 | 17 | 19 | 18 |
| 60 | 16 | 19 | 17 | 22 | 18 |
| 120 | 24 | 26 | 20 | 26 | 24 |
| 128 | 12 | 14 | 14 | 18 | 16 |
| 159 | 22 | 23 | 20 | 26 | - |
| 160 | 22 | 22 | 21 | 25 | 22 |
| 300 | 16 | 19 | 18 | 22 | 20 |
| 320 | 24 | 27 | 26 | 30 | 28 |
| 500 | 26 | 29 | 28 | 32 | 28 |
| 640 | 26 | 31 | 34 | 34 | 30 |
| 864 | 21 | 31 | 29 | 31 | 30 |
| 1024 | 25 | 27 | 25 | 33 | 30 |
| 1784 | 30 | 39 | 42 | 51 | 42 |
| 2480 | 19 | 22 | 22 | 26 | 26 |
| 3072 | 25 | 35 | 41 | 47 | 50 |
| 3200 | 25 | 35 | 42 | 46 | 40 |
| 3568 | 34 | 38 | 42 | 54 | 56 |
| 4096 | 19 | 23 | 22 | 26 | 26 |

Table 9: Effective free distance of a turbo encoder with total code rate $R = 1/3$ using different component RSC's and the 3GPP/UMTS random interleaver [15].

**References**

[1] S. Benedetto and E. Biglieri. "*Principles of Digital Transmission with Wireless Applications*". Kluwer Academic.

[2] S. Lin & D. J. Costello, Jr. "*Error Control Coding: Fundamentals and Applications*". Prentice Hall.

[3] J. G. Proakis. "*Digital Communications*". McGraw-Hill, 1995.

[4] L.H.Ch. Lee. "*Convolutional Coding: Fundamentals and Applications*". Artech House Telecommunications Library, 1997.

[5] M. Bossert. "*Kanalcodierung*". B.G.Teubner, 1998.

[6] A. Graell i Amat, G. Montorsi, S. Benedetto. "*A new approach to the construction of high-rate convolutional codes*". IEEE Communications Letters, Vol. 5, No. 11, November 2001.

[7] Bronstein, Semendjajew, Musiol, Mhlig. "*Taschenbuch der Mathematik*". Verlag Harry Deutsch, 1999.

[8] B. Friedrichs. "*Kanalcodierung*". Springer Verlag, 1994.

[9] H. Meyr. "*Regelungstechnik und Systemtheorie, Teil 1* + 2". Verlag der Augustinus-Buchhandlung, 1992.

[10] L. R. Bahl, J. Cocke, F. Jelinek, J. Raviv. "*Optimal decoding of linear codes for minimizing symbol error rate*". IEEE Transactions of Information Theory, 1974.

[11] A. Viterbi. "*Error bounds for convolutional codes and* an *asymptotically optimum decoding algorithm*". IEEE Transactions on Information Theory, 1967.

[12] R. C. Hartmann, L. D. Rudolph. "*An optimum symbol-by-symbol decoding rule for linear codes".* IEEE Transactions on Information Theory, vol. IT-22, pp. 514-517, Sept. 1976.

[13] J. Hagenauer, E. Offer, L. Papke. "*Iterative decoding of binary block and convolutional codes".* IEEE Transactions on Information Theory, vol. 42, no. 2, pp. 429-445, March 1996.

[14] J. Berkmann, C. Weiß. "*On dualizing Trellis-based APP decoding algorithms*". IEEE Transactions on Information Theory, vol. 50, no. 11, pp. 1743-1757, Nov. 2002.

[15] "*3rd Generation Partnership Project; Technical Specification Group Radio Access Network; Multiplexing and channel coding (FDD) (Release 5)* ". 3GPP TS 25.212 V5.4.0, March 2003. pp. 1743-1757, Nov. 2002.

[16] "*Standard Air Interface for Fixed Broadband Wireless Access Systems-Media Access Control Modifications and Additional Physical Layer for 2-11 GHz*". P802.16ab-01/01r2, pp. 224, Sept. 2001.

[17] R. Johannesson, E. Wittenmark. *"Two 16-state, rate R=2/4 trellis codes whose free distances meet the Heller bound*". IEEE Transactions on Information Theory, vol. 44, no. 4, pp. 1602-1604, July, 1998.

[18] A. R. Calderbank, G. D. Forney, Jr. A. Vardy "*Minimal tail-biting trellises: the Golay code and more*". IEEE Transactions on Information Theory, vol. 45, no. 5, pp. 1435-1455, July, 1999.

[19] A. R. Calderbank. "*The art of signaling: fifty years of coding theory*". IEEE Transactions on Information Theory, vol. 44, no. 6, pp. 2561-2595, Oct. 1998.

[20] Lin-Nan Lee. "*Short unit-memory byte-oriented binary convolutional codes having maximal free distance*". Correspondence, pp. 349-352, July 1975.

[21] G. S. Lauer. "*Some* optimal *partial-unit-memory codes".* IEEE Transactions on Information Theory, vol.-IT 25, no. 2, pp. 240-243, March, 1979.

**Claims**

**1.** A method for terminating a linear convolutional encoder, whereby a code rate of the encoder is defined by R=k/n with k≤n whereby k,n are positive integer numbers, an initial state vector $\mathbf{x}_{(t=p)}$ of the encoder is given and the encoder is mathematically determined by a state input matrix **B**, a state propagation matrix **A**, an encoder output matrix **D** and a state output matrix **C**,
**characterised in that**:

-   a generalised right-hand side pseudo inverse $\mathbf{Q^{(-1)}}_{\text{termination}}$ is calculated from a termination matrix $\mathbf{Q}_{\text{termination}}$ = $\mathbf{[A^{(\theta-1)}B, ..., AB, B]}$, which is a sub matrix of a controllability matrix $\mathbf{Q}_{\text{controllability}}$ = $\mathbf{[A^{(\mu-1)}B, ..., AB, B]}$ of the encoder with $\theta<=\mu$, wherein the termination matrix and the controllability matrix have a full row rank $\mu$ and are exponential series of the state propagation matrix **A** multiplied with the state input matrix **B**,
-   and wherein said generalised right-hand side pseudo inverse is multiplied with a sum of a desired termination state vector $\mathbf{x}_{(t=p+\theta)}$ and the propagated initial state vector $\mathbf{A^{\theta}x}_{(t=p)}$, such that the product determines a termination sequence $[\mathbf{u}_{(t=p)}{}^{T}, ..., \mathbf{u}_{(t=p+\theta-2)}{}^{T}, \mathbf{u}_{(t=p+\theta-1)}{}^{T}]^{T} = \mathbf{Q^{(-1)}}_{\text{termination}}{}^{*} [\mathbf{x}_{(t=p+\theta)} - \mathbf{A^{\theta}x}_{(t=p)}]$, which terminates the encoder in $\theta$ steps, wherein $\mu$ is the number of memory elements of the encoder.

**2.** The method as claimed in claim 1, **characterised in that** a value is chosen for the exponential $\theta$ such that the multiplication of the generalised right-hand side pseudo inverse $\mathbf{Q^{(-1)}}_{\text{termination}}$ with a sum of the termination state vector $\mathbf{x}_{(t=p+\theta)}$ and the propagated initial state vector $\mathbf{A^{\theta}x}_{(t=p)}$ determines a shortest possible termination sequence $[\mathbf{u}_{(t=p)}{}^{T}, ..., \mathbf{u}_{(t=p+\theta-2)}{}^{T}, \mathbf{u}_{(t=p+\theta-1)}{}^{T}]$.

**3.** The method as claimed in claim 1 or 2, **characterized in that** the encoder has an optimum distance spectrum.

**4.** The method as claimed in claim 1, 2 or 3, **characterized in that** the encoder uses a recursive systematic code in observer canonical form.

**5.** The method as claimed in claim 1, 2, 3 or 4, **characterized in that** the encoder is a component of a parallel or a serial concatenation of at least two encoders.

**6.** The method as claimed in claim 5, **characterized in that** it is applied to at least one other component of the parallel or serial concatenation of at least two encoders.

**7.** The method as claimed in one of the preceding claims, **characterized in that** the desired termination state vector $\mathbf{x}_{(t=p+\theta)}$ is equal to zero, $\mathbf{x}_{(t=p+\theta)}$ = 0.

# FIG 1

$$u_{(t)} \longrightarrow \boxed{\begin{array}{c} \text{[ABCD] system} \\ x_{(t+1)} = B^*u_{(t)} + A^*x_{(t)}; \\ y_{(t)} = D^*u_{(t)} + C^*x_{(t)}; \end{array}} \longrightarrow y_{(t)}$$

$$z^{(-1)}$$

$$G_{(z)} = Y_{(z)}/U_{(z)}$$

# FIG 3

# FIG 2

EP 1 583 246 A1

# FIG 4

EP 1 583 246 A1

# FIG 5

# FIG 6

EP 1 583 246 A1

# FIG 7A

Extended Trellis with $2^\mu = 8$ states

Feed-forward non-systematic CCode; R=1/3; K=4, G=[16 7 5];

# FIG 7B

Shortened Trellis with $2^\mu = 4$ states

Feed-forward non-systematic CCode; R=2/3; K=2, G=[16 7 5];

FIG 8A

Log-likelihood information sequences

Comparison of the information sequences with G=[16 7 5];

Information sequence of length 36; Termination bits are not displayed.

⋄ Original info sequence
□ Decoded info LLR seq. K=2; R=2/3;
○ Hard decision info seq. K=2; R=2/3;
—*·· Decoded info LLR seq. K=4; R=1/3;
–*– Hard decision info seq. K=4; R=1/3;

EP 1 583 246 A1

## FIG 8B

**Log-likelihood code sequences**

**Shortened code sequences, corresponding to rate R=2/3; G=[16 7 5];**

Legend:
- ◇ Original code sequence
- □ Decoded code LLR seq. K=2; R=2/3;
- ○ Hard decision code seq. K=2; R=2/3;
- —✱·· Decoded shortened code LLR seq. K=4; R=1/3;
- -✱- Hard decision shortened code seq. K=4; R=1/3;

Shortened code sequence of length 57 including termination bits.

# FIG 9A

Bit metrics of the code sequence according to equation 75 and 80.

$R = 2/3$; $B = [20\ 10]$; $A = [4\ 2\ 1\ 0\ 0]$; $D = [1\ 2\ 3]^T$; $C = [15\ 12\ 37]^T$; $\mu = 5$;

Code sequence of length 309 including termination bits.

—o— transmitted code bits
--o-- Log-MAP bit metrics
--*-- Max-Log-MAP bit metrics

# FIG 9B

Symbol metrics for the code sequences according to equation 79 and using the symbol-to-bit mapping from equation 82.

$R=2/3$; $B=[20\ 10]$; $A=[4\ 2\ 1\ 0\ 0]$; $D=[1\ 2\ 3]^T$; $C=[15\ 12\ 37]^T$; $\mu=5$;

Code sequence of length 309 including termination bits.

—⊙— transmitted code bits
--⊙-- Log-MAP symbol metrics
--✱-- Max-Log-MAP symbol metrics

EP 1 583 246 A1

FIG 10A

Bit metrics of the information sequence according to equation 75 and 80.

$R = 2/3$; $B = [20\ 10]$; $A = [4\ 2\ 1\ 0\ 0]$; $D = [1\ 2\ 3]^T$; $C = [15\ 12\ 37]^T$; $\mu = 5$;

Information sequence of length 200; Termination bits are not displayed.

—⊖— transmitted info bits
—◇— Log-MAP bit metrics
—×— Max-Log-MAP bit metrics

EP 1 583 246 A1

FIG 10B Symbol metrics for the information sequences according to equation 79 and using the symbol-to-bit mapping from equation 81.

$R = 2/3;\ B = [20\ 10];\ A = [4\ 2\ 1\ 0\ 0];\ D = [1\ 2\ 3]^T;\ C = [15\ 12\ 37]^T;\ \mu = 5;$

Information sequence of length 200; Termination bits are not displayed.

—○— Transmitted info bits
- -◇- - Log-MAP symbol metrics
···✕··· Max-Log-MAP symbol metrics

EP 1 583 246 A1

# FIG 11A

Source flowchart

# FIG 11B

Detour flowchart

# FIG 12A
Source flowchart

# FIG 12B
Detour flowchart

# FIG 13A

Rate R=1/2 component RSC of the 3GPP/UMTS turbo code [15].

# FIG 13B

Rate R=1/2 component RSC of the IEEE 802.16ab turbo code [16].

# FIG 13C

Two rate R=1/2 component RSC's with identical optimum distance profiles.

# FIG 14A

Two rate R=1/2 component RSC's with identical optimum distance profiles.

# FIG 14B

Rate R=2/4 component RSC with optimum distance profile derived from [17].

# FIG 14C

Rate R=2/4 component RSC with optimum distance profile according to[17].

# FIG 15A

Rate R=4/8 component RSC derived from the extended Golay convolutional code [18].

# FIG 15B

Rate R=4/8 component RSC derived from the Lauer-Lee type convolutional code [19], [20] and [21]

**European Patent Office**

**EUROPEAN SEARCH REPORT**

Application Number

EP 04 10 5655

## DOCUMENTS CONSIDERED TO BE RELEVANT

| Category | Citation of document with indication, where appropriate, of relevant passages | Relevant to claim | CLASSIFICATION OF THE APPLICATION (Int.Cl.7) |
|---|---|---|---|
| X | R. JOHANNESSON AND K. SH. ZIGANGIROV: "Fundamentals of Convolutional Coding,Convolutional Encoders - Structural Properties" 1999, IEEE PRESS , PISCATAWAY, NJ : IEEE, US , XP002317265 ISBN: 0-7803-3483-3 * page 32 - page 108 * * page 46, line 1 - line 12 * ----- | 1-7 | H03M13/23 |
| A | D. DIVSALAR AND F. POLLARA: "Turbo Codes for Deep-Space Communications" TDA PROGRESS REPORT, [Online] no. 42-120, 15 February 1995 (1995-02-15), pages 29-39, XP002317264 Retrieved from the Internet: URL:http://tmo.jpl.nasa.gov/tmo/progress_r eport/42-120/120D.pdf> * page 30, paragraph A * ----- | 1-7 | |

TECHNICAL FIELDS SEARCHED (Int.Cl.7)

H03M

The present search report has been drawn up for all claims

| Place of search | Date of completion of the search | Examiner |
|---|---|---|
| The Hague | 17 February 2005 | Van Staveren, M |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)